# EUROPEAN PATENT SPECIFICATION

(11) **EP 3 724 912 B1**
(45) Date of publication and mention of the grant of the patent: **27.08.2025**
(21) Application number: 17934871.9
(22) Date of filing: 15.12.2017
(51) Int. Cl.: H01J 37/32, C23C 16/458, C23C 16/50, H01L 21/687

(54) **EDGE RING FOR USE IN A PLASMA PROCESSIGN CHAMBER AND SYSTEM FOR SECURING SUCH AN EDGE RING**
KANTENRING ZUR VERWENDUNG IN EINER PLASMAPROZESSKAMMER UND SYSTEM ZUR BEFESTIGUNG EINES SOLCHEN KANTENRINGES
ANNEAU DE BORD À UTILISER DANS UNE CHAMBRE DE TRAITEMENT AU PLASMA ET SYSTÈME DE FIXATION D'UN TEL ANNEAU DE BORD

(43) Date of publication of application: 21.10.2020
(73) Proprietor: Lam Research Corporation, Fremont, CA 94538 (US)
(72) Inventor: KELLOGG, Michael, C., Fremont, CA 94538 (US); MACE, Adam, Fremont, CA 94538 (US); MARAKHTANOV, Alexei, Fremont, CA 94538 (US); HOLLAND, John, Fremont, CA 94538 (US); CHEN, Zhigang, Fremont, CA 94538 (US); KOZAKEVICH, Felix, Fremont, CA 94538 (US); MATYUSHKIN, Alexander, Fremont, CA 94538 (US)
(74) Representative: Mewburn Ellis LLP
(86) International application number: PCT/US2017/066874
(87) International publication number: WO 2019/117969

(56) References cited:
- EP-A1- 1 332 241
- WO-A1-2017/069238
- KR-A- 20160 079 662
- US-A1- 2008 006 207
- US-A1- 2011 287 632
- US-A1- 2013 292 056
- US-A1- 2014 367 047
- US-A1- 2015 179 412
- US-A1- 2016 181 142
- US-A1- 2016 181 142
- US-A1- 2016 211 166
- US-A1- 2017 069 471
- US-A1- 2018 308 737

## Description

### Field

The present embodiments relate to rings, systems, methods, and structures for securing the rings in a plasma chamber.

### Background

A plasma chamber is used to perform various processes on a wafer. For example, the plasma chamber is used for cleaning the wafer, depositing materials on the wafer, or etching the wafer. The plasma chamber includes various components, such as a variety of rings, that are used for processing different portions of the wafer.

It is in this context that embodiments described in the present disclosure arise.

US2016/181142A1 discloses an edge ring and process for fabricating an edge ring. In one example, an edge ring includes an annular body and a plurality of thermal breaks disposed within the annular body. The thermal breaks are disposed perpendicular to a center line of the annular body of the edge ring. US 2008/006207 A1 discloses a heat-transfer sheet made of a gel-like material being interposed between the focus ring and the electrostatic chuck. Since the heat-transfer sheet made of the gel-like material is fluid, the minute gaps are filled fully to increase the degree of adhesion between the focus ring and the electrostatic chuck, whereby heat transference between the focus ring and the electrostatic chuck can be improved. US 2016/211166 A1 discloses a substrate processing system including a processing chamber and a pedestal arranged in the processing chamber. An edge coupling ring is arranged adjacent to a radially outer edge of the pedestal. A first actuator is configured to selectively move the edge coupling ring to a raised position, relative to the pedestal to provide clearance between the edge coupling ring and the pedestal to allow a robot arm to remove the edge coupling ring from the processing chamber.

### Summary

According to a first aspect of the present invention there is provided an edge ring for use in a plasma processing chamber as specified in claim 1. The edge ring may optionally be as specified in any of claims 2 to 7.

According to a second aspect of the present invention there is provided a system for securing an edge ring of a plasma chamber as specified in claim 8. The system may optionally be as specified in any one of claims 9 to 12.

In the described embodiments, a plasma chamber is provided with an edge ring and a support ring. In one embodiment, the edge ring is coupled to the support ring that is disposed below the edge ring. The edge ring is, for example, coupled to the supporting ring by a plurality of screws that attach to an underside of the edge ring. To secure the support ring, a plurality of pull-down structures coupled to an underside of the support ring, which pull down to maintain the edge ring secured during processing. If the edge ring is not properly secured during processing, adhesives used to secure the edge ring are not enough. One reason that adhesives alone are not enough is that an adhesive force provided by an adhesive gel formed between the support ring and the edge ring is reduced due to high temperature cycles within the plasma chamber. Additionally, there is a constant force being applied to the gel and so the gel can disintegrate over time. Thus, it is desired that the edge ring and the support ring remain in place during processing of the substrate even when the adhesive force provided by the gel is reduced and/or the gel disintegrates. By way of example, it is desirable that the edge ring be fixed with respect to the support ring during the processing of the substrate. Otherwise, any displacement of the edge ring during processing of the substrate may result in an undesirable process being performed on the substrate or certain portions of the substrate that are not desired to be processed are processed. In one embodiment, a bottom surface of the edge ring has slots, e.g., screw holes, for receiving multiple fasteners to connect the edge ring to the support ring during processing of the substrate. This assists in preventing the edge ring from moving with respect to the support ring.

In one embodiment, it is desired that the edge ring have one or more curved edges to reduce chances of arcing when plasma is formed within the plasma chamber.

In another embodiment, it is desired that a cover ring is provided to surround the edge ring. The cover ring is further configured to have one or more edges that are curved to reduce chances of arcing when plasma is formed within the plasma chamber. Also, a width of the cover ring is selected such that a tracking distance along the width facilitates achievement of a stand-off voltage at a vertically oriented inner surface of the cover ring. For example, if radio frequency (RF) voltage dissipated within the cover ring ranges from and including about 7 volts (V) to 10 volts per 3 hundredths of a mm (thousandth of an inch) of the cover ring, to achieve a pre-determined 5000 volts (V) stand-off voltage at the vertically oriented inner surface of the cover ring, the width of the cover ring corresponds to the tracking distance. The tracking distance is a ratio of a multiple, such as two or three, of the stand-off voltage and the voltage dissipation within per unit length, such as the 3 hundredths of a mm (thousandth of an inch), of the cover ring. In some embodiments, the width of the cover ring is the tracking distance that is provided by the ratio. In another embodiment, the surface length between the edge ring and ground, e.g., along a number of stepped surfaces defines the tracking distance.

In one embodiment, it is desirable that the support ring and the edge ring be fixed with respect to an insulator ring, which is situated under the support ring. Otherwise, any movement of the support ring with respect to the insulator ring moves the edge ring on top of the support ring. The movement of the edge ring is undesirable during processing of the substrate. Any displacement of the support ring during processing of the substrate may result in an undesirable process being performed on the substrate or certain portions of the substrate that are not desired to be processed are processed. Also, it is desirable that the support ring and the edge ring be removed easily for maintenance or replacement of the support ring or the edge ring or both the edge ring and the support ring.

In some embodiments, an edge ring for use in a plasma processing chamber is described. The edge ring has an annular body that surrounds a substrate support of the plasma processing chamber. The annular body has a bottom side, a top side, an inner side, and an outer side. The edge ring has a plurality of fastener holes disposed into the annular body along the bottom side. Each fastener hole has a threaded inner surface for receiving a fastener used for attaching the annular body to a support ring. The edge ring further includes a step disposed at the inner side of the annular body. The step has a lower surface separated from an upper surface of the top side by an angled surface. The edge ring has a curved edge formed between the upper surface of the top side and a side surface of the outer side.

In several embodiments, a cover ring for use in a plasma processing chamber is described. The cover ring has an annular body that surrounds an edge ring and is adjacent to a ground ring. The annular body has an upper body portion, a middle body portion, and a lower body portion. The middle body portion defines a step reduction from the upper body portion such that the middle body portion has a first annular width. The lower body portion defines a step reduction from the middle body portion such that the lower body portion has a second annular width that is smaller than the first annular width.

In various embodiments, a system for securing an edge ring of a plasma chamber is described. The system includes a support ring over which the edge ring is oriented. The system further includes a gel layer disposed between a bottom surface of the edge ring and a top surface of the support ring. The system also includes a plurality of screws configured to secure the edge ring to the support ring. Each of the plurality of screws is attached to screw holes disposed in the bottom surface of the edge ring and passing through the support ring. The system also includes a plurality of hold down rods connected to a bottom surface of the support ring. The system includes a plurality of pneumatic pistons. Each of the plurality of pistons is coupled to respective ones of the plurality of hold down rods.

Some advantages of the herein described systems and methods include providing the edge ring having the one or more curved edges, which are not sharp. A sharp edge, such as an edge having a 90° angle, usually is responsible for arcing of RF power when plasma is formed within the plasma chamber. The one or more curved edges reduce chances of such arcing.

Further advantages of the systems and methods include providing the edge ring with one or more slots, such as screw holes, for receiving fasteners, such as screws, for coupling the edge ring to the support ring. The coupling of the edge ring with the support ring fixates the edge ring with respect to the support ring even when an adhesion force provided by the gel between the edge ring and the support ring is reduced or the gel wears off or the gel is disintegrated due to a force applied on the gel during the processing of the substrate. Moreover, the support ring is fixated with respect to the insulator ring via one or more hold down rods. Accordingly, the edge ring is fixed with respect to the insulator ring via the support ring and therefore, the edge ring cannot be displaced during the processing of the substrate. Such lack of displacement reduces chances of, such as avoids, any undesirable process being performed on the substrate or reduces chances of undesirable areas of the substrate from being processed.

Additional advantages of the systems and methods include providing one or more mechanisms, such as one or more pneumatic mechanisms, for pulling down or pushing up on the support ring via the one or more hold down rods. The pull down is performed during the processing of the substrate to reduce chances of the support ring from being displaced with respect to the insulator ring. As such, due to the pull down, and the edge ring and the support ring remain fixed within the plasma chamber during multiple processing operations, such as from processing operation to another, until being replaced or removed from the plasma chamber for maintenance. The push up is performed to remove the edge ring or the support ring for replacement or maintenance, such as cleaning.

Further advantages of the herein described systems and methods include providing the cover ring with the one or more curved edges to reduce chances of arcing when plasma is formed within the plasma chamber. Moreover, the cover ring has the annular width to achieve the stand-off voltage at the vertically oriented inner surface of the cover ring as described above.

Other aspects will become apparent from the following detailed description, taken in conjunction with the accompanying drawings.

### Brief Description of the Drawings

The embodiments may best be understood by reference to the following description taken in conjunction with the accompanying drawings.
Figure 1 is a diagram of an embodiment of a system to illustrate a manner of securing an edge ring to a support ring.
Figure 2 is a diagram of an embodiment of a system to illustrate coupling of a power pin to the support ring.
Figure 3A is a diagram of an embodiment of a system to illustrate multiple locations for connecting multiple hold down rods to the support ring.
Figure 3B is an isometric view to illustrate a coupling of a hold down rod with a bottom surface of the support ring.
Figure 4 is a side view of an embodiment of a system for securing an edge ring and the support ring to an insulator ring.
Figure 5 is an isometric view of an embodiment of a clasp mechanism.
Figure 6A is a diagram of an embodiment of a system for illustrating a synchronous pull down of the hold down rods.
Figure 6B is a diagram of an embodiment of a system for illustrating a synchronous push up of the hold down rods.
Figure 7 is a block diagram of an embodiment of a system to illustrate a supply of air to multiple clasp mechanisms.
Figure 8A is an isometric view of an embodiment of an edge ring.
Figure 8B is a top view an embodiment of the edge ring of Figure 8A.
Figure 8C is a cross-sectional view of the edge ring of Figure 8A.
Figure 8D is a diagram of an embodiment of a system to illustrate a coupling of a fastener to the edge ring of Figure 8A.
Figure 9A is an isometric view of an embodiment of a cover ring.
Figure 9B is a bottom view of an embodiment of the cover ring of Figure 9A.
Figure 9C is a top view of an embodiment of the cover ring of Figure 9A.
Figure 9D is a cross-sectional view of an embodiment of the cover ring of Figure 9A.
Figure 9E is a cross-sectional view of an embodiment of the cover ring of Figure 9A.
Figure 9F is a cross-sectional view of an embodiment of the cover ring of Figure 9A.
Figure 9G is a cross-sectional view of an embodiment of a cover ring.

### DETAILED DESCRIPTION

The following embodiments describe systems and methods for securing an edge ring within a plasma chamber. It will be apparent that the present embodiments may be practiced without some or all of these specific details. In other instances, well known process operations have not been described in detail in order not to unnecessarily obscure the present embodiments.

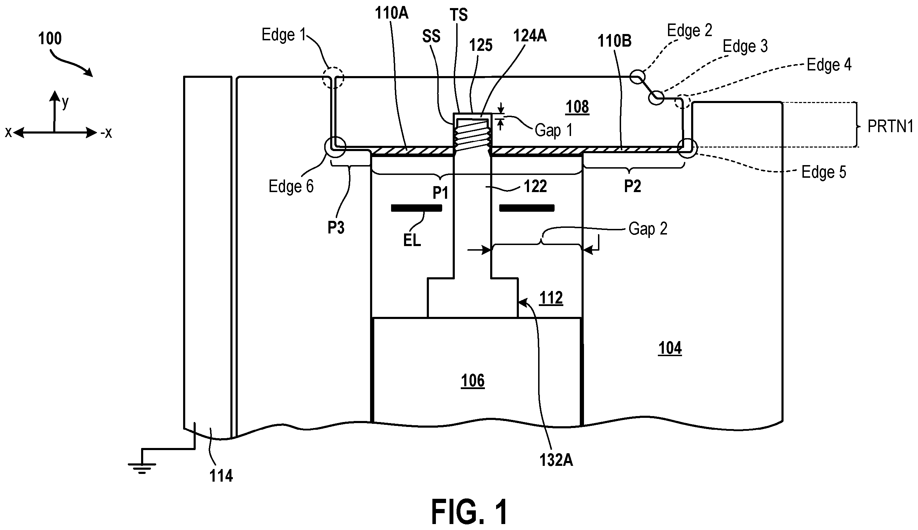

Figure 1 is a diagram of an embodiment of a system 102 to illustrate a manner of securing an edge ring 108 to a support ring 112, which is sometimes referred to herein as a tunable edge sheath (TES) ring. The system 100 includes the edge ring 108, a ground ring 114, a base ring 116, an insulator ring 106, a cover ring 118, and a chuck 104. The edge ring 108 is made of a conductive material, such as silicon, boron doped single crystalline silicon, alumina, silicon carbide, or silicon carbide layer on top of alumina layer, or an alloy of silicon, or a combination thereof. It should be noted that the edge ring 108 has an annular body, such as a circular body, or ring-shaped body, or dish-shaped body. Moreover, the support ring 112 is made from a dielectric material, such as quartz, or ceramic, or alumina (Al₂O₃), or a polymer. As an example, the support ring 112 has an inner diameter of about 31.8 cm (12.5 inches), an outer diameter of about 34.3 cm (13.5 inches), and a thickness, along a y-axis of about 1 cm (0.5 inch). To illustrate, the support ring 112 has the inner diameter ranging from and including about 32.3 cm (12.7 inches) to about 33 cm (13 inches), the outer diameter from and including about 33.8 cm (13.3 inches) to about 36 cm (14 inches), and the thickness from and including about 1 cm (.5 inch) to about 2 cm (.7 inch). This is just an example dimension for the plasma chamber used for processing a 300 millimeter wafer.

Furthermore, the insulator ring 106 is made from an insulator material, such as the dielectric material, and the base ring 116 is also fabricated from the dielectric material. The ground ring 114 is made from the conductive material. The ground ring 114 is coupled to a ground potential. An example of the chuck 104 includes an electrostatic chuck. Each ring, such as the edge ring 108, the support ring 112, the ground ring 114, the base ring 116, and the insulator ring 106 has an annular shape, such as a shape of a ring or a shape of a disk. The cover ring 118 is made from a dielectric material, such as fused silica - quartz, or a ceramic material, such as, aluminum oxide (Al₂O₃) or Yttrium oxide (Y₂O₃). The cover ring 118 has an annular body, such as that of a disk-shape or a ring-shape.

A bottom surface of the edge ring 108 has a portion P1 that is coupled to the upper surface of the support ring 112 via a thermally conductive gel layer 110A to thermally sink the support ring 112 to the edge ring 108. Examples of a thermally conductive gel, as used herein, include polyimide, polyketone, polyetherketone, polyether sulfone, polyethylene terephthalate, fluoroethylene propylene copolymers, cellulose, triacetates and silicone. Moreover, the bottom surface of the edge ring 108 has another portion P2 that is coupled to an upper surface of the chuck 104 via a thermally conductive gel layer 110B. In addition, the bottom surface of the edge ring 108 has yet another portion P3 that is located above and adjacent to the base ring 116.

The edge ring 108 is located above the base ring 116, the support ring 112, and the chuck 104. The bottom surface of the edge ring 108 faces the base ring 116, the support ring 112, and a portion of the chuck 104. The edge ring 108 also surrounds a portion, such as a top portion PRTN1, of the chuck 104. The support ring 112 surrounds a portion of the chuck 104 and the insulator ring 106 surrounds another portion of the chuck 104. The base ring 116 surrounds the support ring 112 and a portion of the insulator ring 106. The cover ring 118 surrounds the edge ring 108 and the base ring 116. The ground ring 114 surrounds a portion of the cover ring 118 and the base ring 116. A portion of the cover ring 118 is located above the ground ring 114 and the cover ring 118 is located adjacent to a side portion of the ground ring 114.

The edge ring 108 has multiple edges, such as an edge 1, and edge 2, and edge 3, and edge 4, an edge 5, and an edge 6. Each edge 1 through 6 is curved, such as arced. To illustrate, each edge 1 through 6 lacks sharpness, has a radius, and has a smooth curve. It should be noted that in various embodiments, the radius of each of the edges 1 through 6 is greater than a range from and including about 0.3 mm (0.01 inch) to about 0.8 mm (0.03 inch). The radius of the edge from and including about 0.3 mm (0.01 inch) to about 0.8 mm (0.03 inch) reduces chances of chipping of the edge during fabrication of a semiconductor wafer. The chipping creates particles during processing of the semiconductor wafer.

In one embodiment, the edge ring 108 has a plurality of edges. The edges that define the edge ring 108, in one embodiment, are rounded. By way of example, edge 1 of the edge ring 108 is rounded to a radius that is about 0.8 mm (.03 inch) or greater, and preferably greater than 2 mm (.07 inch). To illustrate, the edge 1 is rounded to have a radius ranging from and including about 0.8 mm (0.03 inch) to about 3 mm (0.1 inch). As another illustration, the edge 1 is rounded to have a radius ranging from and including about 2 mm (0.07 inch) to about 3 mm (0.1 inch). Edge 1 of the edge ring 108 is particularly susceptible to arcing, due to its proximity to ground ring 114. Due to the increased power levels being used in plasma processing operations, a high electric field will be generated between edge ring 108 and ground ring 114. The rounding of the edge 1 reduces chances of such arcing. It has been determined that less rounding of these edges may not suffice to prevent or reduce chances of arcing of RF power when the plasma chamber is in operation. The reduction of chances of arcing, influenced by sharper edges of features within the plasma chamber, may be detrimental to a fabrication process being performed over and on semiconductor wafers. Slight rounding of the edges, e.g. edge 1 ranging from and including about 0.3 mm (.01 inch) to about 0.8 mm (.03 inch), assists in reducing a possibility of particle generation during fabrication of semiconductor wafers, or chipping of the edges during the fabrication. Thus, although some rounding was performed on surfaces of features, e.g. edge 1, disposed within the plasma chamber, this rounding is less than that for preventing or reducing arcing in light of the increased power levels being used in plasma processing operations.

The curved edges 1 through 6 reduce chances of chipping or arcing when plasma is formed within a plasma chamber in which the system 100 is situated. It should be noted that the edge 5 is rounded less compared to the edge 1 to reduce chances of plasma ions of the plasma from entering in a gap between the edge 5 and the chuck 104. For example, a radius of the edge 5 is lower than a radius of the edge 1. As an example, the edge ring 108 has an outer diameter, along an x-axis, that ranges from and including about 34.5 cm (13.6 inches) to about 38 cm (15 inches). As another example, the edge ring 108 has an outer diameter that ranges from and including about 33 cm (13 inches) to about 38 cm (15 inches). As yet another example, the edge ring 108 has a thickness, measured along the y-axis, of about 6.30 mm (.248 inch). To illustrate, the thickness of the edge ring 108 ranges from and including about 6.1 mm (.24 inch) to about 6.50 mm (.256 inch). The x-axis is perpendicular to the y-axis. As the outer diameter of the edge ring 108 gets larger, a distance between an outer side surface contiguous with the edge 1 of the edge ring 108 and the cover ring 118 is reduced. The reduction in the distance reduces chances of arcing of RF power between the edge ring 108 and the cover ring 118 when plasma is formed within the plasma chamber.

The edge ring 108 includes multiple slots, such as a slot 125, formed within the bottom surface of the edge ring 108. An example of a slot within an edge ring is a screw hole. Each slot surrounds a fastener hole, such as a fastener hole 124A. The fastener holes do not extend fully along a length, along the y-axis, of the edge ring 108 to form through holes within the edge ring 108. The multiple fastener holes are formed within the bottom surface of the edge ring 108. An example of a fastener hole is a screw hole having spiral threads for receiving a screw. The slot 125 has a top surface TS and a side surface SS. The top surface TS and the side surface SS are surfaces formed by drilling into the bottom surface of the edge ring 108. The side surface SS is substantially perpendicular to the top surface TS. For example, side surface SS is angled, such as forms an angle ranging between 85 degrees and 95 degrees, with respect to the top surface TS. As another example, the side surface SS is perpendicular to the top surface TS. The top surface TS partially encloses the fastener hole 124A and the side surface SS partially encloses the fastener hole 124A.

Moreover, a through hole 132A is formed within the support ring 112 for receiving a fastener 122, such as a screw or a bolt or a pin. Similarly, additional through holes, such as the through hole 132A, are formed within the support ring 112 at other locations within the support ring 112 to receive multiple fasteners, such as the fastener 122, for coupling the support ring 112 to an edge ring, described herein. For example, three through holes are formed within the support ring 112 at vertices of an equilateral triangle in a horizontal plane, which is along the x-axis. As another example, six or nine through holes are formed within the support ring 112 and a distance between a set of adj acent ones of the through holes is substantially equal to, such as equal to or within a predetermined limit from, a distance between another set of adjacent ones of the through holes. It should be noted that the set of adjacent ones of the through holes have at least one through hole that is not the same as at least one of the adjacent ones of the through holes of the other set.

The fastener 122 is made from a metal, such as steel, aluminum, an alloy of steel, or an alloy of aluminum. The through hole 132A is formed to conform to a shape of the fastener 122. For example, the fastener 122 has a head that has a larger diameter than the body of the fastener 122. A lower portion of the through hole 132A is fabricated to have a diameter that is slightly larger, such as by a fraction of a millimeter (mm), compared to the head of the fastener 122. Moreover, an upper portion of the through hole 132A is fabricated to have a diameter that is slightly larger, such as by a fraction of a millimeter, compared to the body of the fastener 122. In addition, a diameter of the through hole 124A is fabricated to be slightly larger, such as by a fraction of a millimeter, compared to a threaded portion of the fastener 122. Moreover, a space is formed, along the y-axis, between the top surface TS of the slot 125 and a tip of the fastener 122. An example of the space is a gap 1 that ranges from and including about 0 mm to about 1 mm. Another example of the gap 1 is a space ranging from and including about 0 mm to about .5 mm. Yet another example of the gap 1 is a space ranging from and including about 0 mm to about .25 mm. The space of the gap 1 is in a vertical direction along the y-axis. The space between the top surface TS of the slot 125 and the threaded portion of the fastener 122 ranges from and including about 0 mm to about 0.5 mm to reduce chances of arcing of RF power within the space. If the arcing occurs, the fastener 122 may melt due to heat created as a result of the arcing.

The fastener 122 is inserted within the through hole 132A so that the head and the body of the fastener 122 is located within the support ring 112 and the threaded portion of the fastener 122 is inserted into the fastener hole 124A formed within the edge ring 108. A space, such as a gap 2, formed between a side surface of the fastener 122 and an inner side surface of the support ring 112 ranges from and including about 0 mm to about 0.2 mm.

The support ring 112 has embedded in it an electrode EL for receiving radio frequency (RF) power of an RF signal received from an auxiliary RF generator via an auxiliary match, such as an impedance matching circuit.

In some embodiments, the support ring 112 is a coupling ring.

In various embodiments, the fastener 122 is made from plastic.

In some embodiments, instead of a conductive gel layer, a two-sided conductive tape, which has a conductive gel on both of its sides, is used. In various embodiments, instead of a conductive gel layer, a caulking bead having a conductive gel is used.

In some embodiments, instead of a fastener hole having multiple threads, the fastener hole within a bottom surface of an edge ring, described herein, is fitted with an insert, such as a metal casing. To illustrate, the metal casing is screwed to a slot formed within a bottom surface of the edge ring. The insert has threads within an inner surface of the insert. A fastener is then screwed to the threads of the insert instead of being screwed to the fastener hole having the threads.

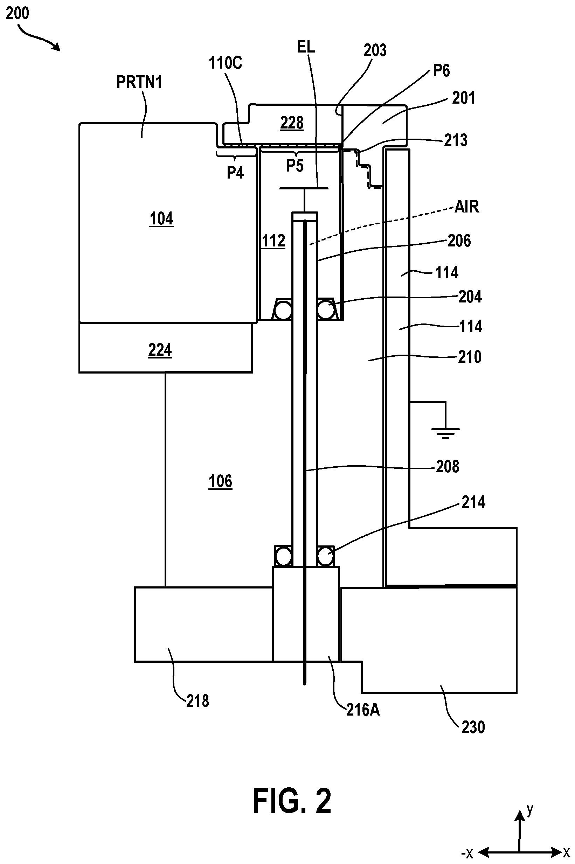

Figure 2 is a diagram of an embodiment of a system 200 to illustrate coupling of a power pin 208 to the support ring 112. The system 200 includes an edge ring 228, a cover ring 201, the ground ring 114, the insulator ring 106, a base ring 210, a facilities plate 224, the chuck 104, the support ring 112, a bowl 218, and an insulator wall 230. The insulator wall 230 is a wall of a bias housing of a plasma chamber, described herein. The insulator ring 106 is fixed, such as not moveable, with respect to the insulator wall 230. The ground ring 114 is uncoated. The edge ring 228 is sometimes referred to herein as a hot edge ring (HER). The edge ring 228 is made of the same material as the edge ring 108 of figure 1 except the edge ring 228 has a different shape than the edge ring 108. As an example, the edge ring 228 has an outer diameter, along the x-axis, that ranges from and including about 34.5 cm (13.6 inches) to about 38 cm (15 inches). As another example, the edge ring 228 has the outer diameter that ranges from and including about 33 cm (13 inches) to about 38 cm (15 inches). As yet another example, the edge ring 228 has a thickness, measured along the y-axis, of about 6.30 mm (.248 inch). To illustrate, the thickness of the edge ring 228 ranges from and including about 6.1 mm (.24 inch) to about 6.50 mm (.256 inch). Multiple fastener holes, such as the fastener hole 124A of Figure 1, is formed within the edge ring 228 to secure the edge ring 228 to the support ring 112.

Moreover, the cover ring 201 is made of the same material as the cover ring 118 of figure 1 except the cover ring 201 has a different shape than the cover ring 118. The cover ring 201 has an annular body, such as that of a disk-shape or a ring-shape. A portion of the cover ring 201 is located above and adjacent to the ground ring 114 and another portion of the cover ring 201 is located adjacent to and above the base ring 210. Similarly, the base ring 210 is made from the same material as the base ring 116 of figure 1 except that the base ring 210 has a different shape than the base ring 116.

A portion P5 of edge ring 228 is coupled to the support ring 112 via a gel layer 110C to thermally sink the support ring 112 to the edge ring 228. Similarly, another portion P4 of the edge ring 228 is coupled to a portion of the chuck 104 via the gel layer 110C. The edge ring 228 surrounds the top portion PRTN1 of the chuck 104. Also, another portion P6 of the edge ring 228 is adjacent to a portion of a top surface of the base ring 210. Moreover, the cover ring 201 surrounds the edge ring 228. The support ring 112 is located below the edge ring 228 and surrounds a portion of the chuck 104. The insulator ring 106 is located below the support ring 112 and surrounds a bottom portion of the chuck 104. The base ring 210 is located below the cover ring 201 and surrounds a portion of the insulator ring 106. The ground ring 114 surrounds the base ring 210 and a portion of the insulator ring 106. The bowl 218 is located below the insulator ring 106. The insulator wall 230 is located below the ground ring 114 and a portion of the insulator ring 106. The insulator wall 230 is fabricated from the insulator material.

A power pin feed through 206 is inserted via a through hole in the insulator ring 106 and a hole formed in the support ring 112. The power pin feed through 206 is a sleeve, made from an insulator, such as plastic or ceramic, to protect the power pin 208. Within the power pin feed through 206 lies the power pin 208. The power pin 208 is a conductive rod made from a metal, such as aluminum or steel, for conduction of RF power to the support ring 112 or to the electrode EL within the support ring 112. A tip of the power pin 208 is in contact with the electrode EL to provide RF power to the electrode EL. A middle portion of the power pin feed through 206 is encased within a mount 216A, which is fabricated from the insulator material.

An O-ring 214 is located above the mount 216A and adjacent to the mount 216A to seal the mount 216A against the power pin feed through 206. The O-ring 214 surrounds the bottom portion of the power pin feed through 206. An example of an O-ring, described herein, is a ring made of a metal, such as aluminum or steel. Moreover, another O-ring 204 is situated at a top portion of the power pin feed through 206 to prevent air between the power pin 208 and the power pin feed through 206 from entering plasma within a plasma chamber in which the system 200 is included. There is no vacuum between the power pin 208 and the power pin feed through 206. The O-ring 204 surrounds the top portion of the power pin feed through 206.

It should be noted that in some embodiments, there are multiple power pins used. For example, two power pins can be used with power pin feed throughs, O-rings that surround the respective bottom portions of the power pin feed throughs, and O-rings that surround the respective top portions of the power pin feed throughs are used to provide power to the electrode EL at multiple locations.

A stand-off RF voltage is created from the RF power of the RF signal that is received from the auxiliary RF generator via the auxiliary match. The stand-off RF voltage has a trackable distance 213 from a vertically oriented inner surface 203 of the cover ring 201 to the ground ring 114. The stand-off RF voltage is created via the trackable distance 213 from the vertically oriented inner surface 203 to the ground ring 114. It should be noted that in some embodiments, an annular width of the cover ring 201 is selected so that the trackable distance 213 between the edge ring 228 and the ground ring 114 is sufficient to lose less than a pre-determined amount of the RF voltage from the edge ring 228 to the ground ring 114. For example, if a pre-determined amount of stand-off voltage at the vertically oriented inner surface 203 of the cover ring 201 to be achieved is 5000 volts (V) and between 7 and 10 volts are dissipated per 3 hundredths of a mm (thousandth of an inch) of the cover ring 201, the annular width of the cover ring 201 is selected such that the trackable distance 213 or the annular width is a ratio of a multiple, such as two or three, of 5000 volts and 10 volts. To illustrate, the ratio is (2 X 5000)/ 10 volts. The trackable distance 213 is in an x-y plane of the cross-section of the cover ring 201. The x-y plane is formed by the x-axis and the y-axis and is located between the x-axis and y-axis.

In some embodiments, multiple power pin feed throughs are coupled to the support ring 112 to provide RF power. Each power pin feed through has a power pin.

In some embodiments, the ground ring 114 is coated with a conductive material, such as alumina, to increase conductivity of the ground ring 114.

In various embodiments, the gel layer 110C is placed at multiple locations along the lower surface of the edge ring 228 and along the upper surface of the support ring 112 and the chuck 104 to provide electrical and thermal conductivity between the edge ring 228 and the support ring 112 and between the edge ring 228 and the chuck 104.

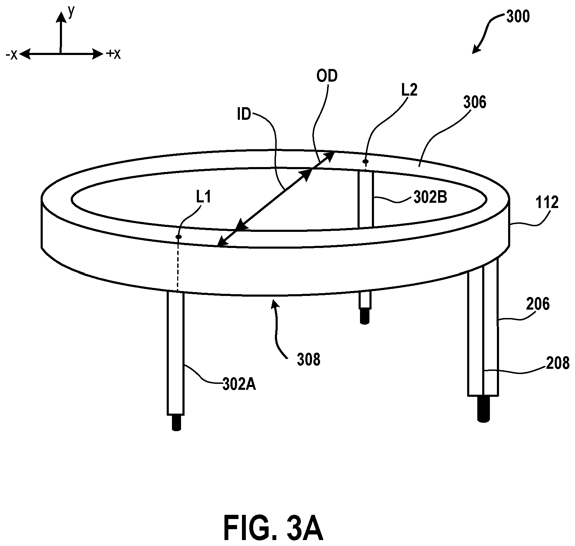

Figure 3A is a diagram of an embodiment of a system 300. Each hold down rod 302A and 302B is inserted via a respective slot in a bottom surface 308 of the support ring 112. For example, the hold down rod 302A is inserted into a first slot at the location L1 in the bottom surface 308 to secure the support ring 112 to the insulator ring 106 at the location L1. Similarly, the hold down rod 302B is inserted into a second slot at the location L2 in the bottom surface 308 to secure the support ring 112 to the insulator ring 106 at the location L2. As another example, each hold down rod 302A- and 302B has a thread at its top portion and the thread mates with a thread of the respective slot formed within the bottom surface 308. As yet another example, each hold down rod 302A- and 302B has a spring based retractable and extendable mechanism that retracts before insertion into the respective slot within the bottom surface 308 and extends after the insertion.

It should be noted that a size of each through hole formed along a length measured along the y-axis of the support ring 112 varies with an outer diameter (OD) and an inner diameter (ID) of the support ring 112. The inner diameter of the support ring 112 varies with a diameter of the chuck 104 of figures 1 and 2.

In various embodiments, any number of hold down rods, such as two or more than two, are used to couple to the support ring 112.

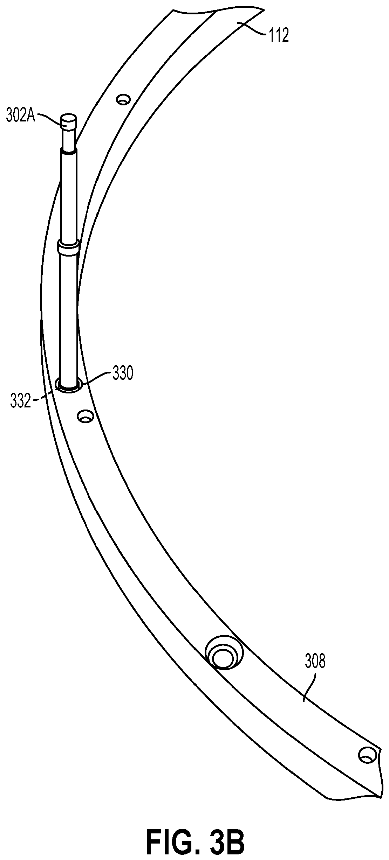

Figure 3B is an isometric view to illustrate a coupling of the hold down rod 302A with the bottom surface 308 of the support ring 112. Formed within the bottom surface is a slot 330 that extends partially along the length of the support ring 112. The length of the support ring 112 is along the y-axis. The slot 330 is fitted with a receptor 332, which is made from a metal, such as aluminum or steel or titanium or an alloy of aluminum or an alloy of steel or an alloy of titanium. For example, the receptor 332 is attached via an attachment mechanism, such as threads, to a surface of the slot 330. To further illustrate, the slot 330 has threads to which threads of the receptor 332 are fitted. A tip of the hold down rod 302A is inserted into the receptor 332 to fit to the receptor 332 to connect the hold down rod 302A to the support ring 112.

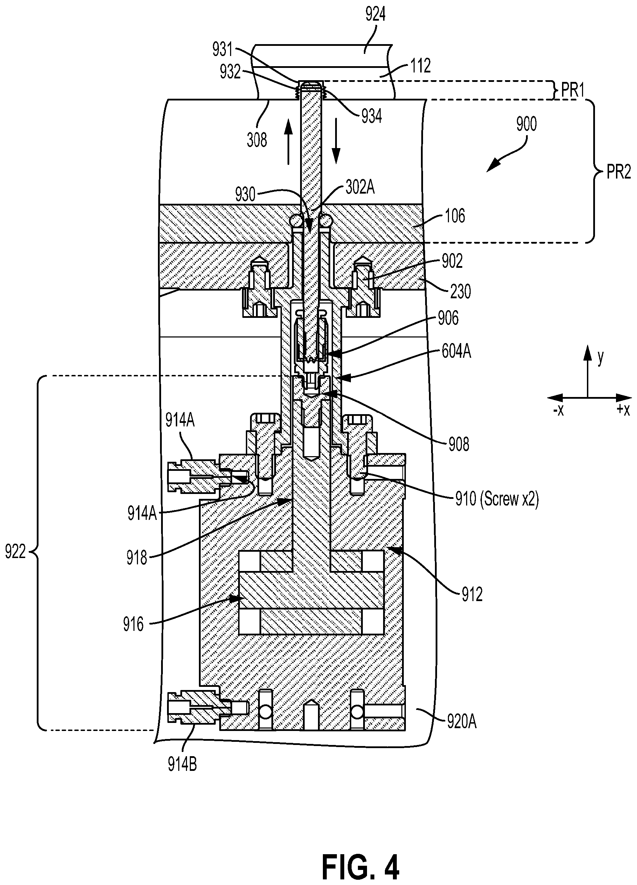

Figure 4 is a side view of an embodiment of a system 900 for securing an edge ring 924 and the support ring 112 to the insulator ring 106. Examples of the edge ring 924 include the edge ring 108 of figure 1 and the edge ring 228 of figure 2. The system 900 includes the clasp mechanism 920A, the insulator ring 106, the support ring 112, and the edge ring 924. The clasp mechanism 920A includes an air cylinder 912, a pneumatic piston 922, a threaded adapter 908, a push connector 906, and the mount 604A for mounting the hold down rod 302A to the insulator wall 230. The mount 604A is mounted to the insulator wall 230 via multiple shoulder screws 902. The clasp mechanism 920A is coupled to multiple air fittings 914, which include an air fitting 914A and an air fitting 914B at a side of the clasp mechanism 920A. A clasp mechanism, described herein, is made from a metal, such as steel, aluminum, an alloy of steel, or an alloy of aluminum, etc. Moreover, the air fittings 914 are also made from a metal, such as steel, aluminum, an alloy of steel, or an alloy of aluminum, etc.

The piston 922 has a piston body 916 and a piston rod 918. Within the air cylinder 912 is the piston body 916. The piston body 916 has a greater diameter than the piston rod 918. The piston body 916 is integrated with or attached to the piston rod 918. The mount 604A is attached to the air cylinder 912 via multiple screws 910 at a top surface of the air cylinder 912. That threaded adapter 908 is inserted into a center opening 930 of the mount 604A. That threaded adapter 908 is fitted into a slot formed within a top surface of the piston rod 918. Moreover, the threaded adapter 908 has a slot for fitting the push connector 906 within the slot. The push connector 906 is fitted with the hold down rod 302A that is inserted via the center opening 930 of the mount 604A. The push connector 906 is attached to, such as screwed to, a bottom portion of the hold down rod 302A.

Similarly, the other hold down rod 302B (Figure 3A) is coupled to another pneumatic mechanisms of clasp mechanism 920B, which are described below. For example, the clasp mechanism 920B includes a piston, such as the piston 922, that is coupled to the hold down rod 302B to move up and down the hold down rod 302B in the vertical direction along the y-axis. The hold down rod 302A has threads 932 at its tip for mating with corresponding threads 934 of a slot 931 formed within the bottom surface 308 of the support ring 112. A top portion PR1 of the hold down rod 302A extends into a slot within the support ring 112 via the bottom surface of the support ring 112 and a middle portion PR2 of the hold down rod 302A extends via a through hole in the insulator ring 106. Similarly, a top portion of the hold down rod 302B extends into a slot within the bottom surface of the support ring 112 and a middle portion of the hold down rod 302B extends into a through hole within the insulator ring 106.

The support ring 112 is physically connected to the edge ring 924 via one or more fasteners, as described above. When air is supplied to a lower portion of the air cylinder 912 via the air fitting 914B, pressure is created by the air under a lower surface of the piston body 916. Due to the pressure created under the lower surface of the piston body 916, the piston 922 moves in a vertically upward direction, along the y-axis, to push up the hold down rod 302A. When the hold down rod 302A is pushed up, the support ring 112 is raised up in the vertically upward direction with respect to the insulator ring 106. Simultaneous with the support ring 112, the edge ring 924 is also raised in the vertically upward direction away from the insulator ring 106. The support ring 112 and the edge ring 924 are pushed up away from the insulator ring 106 in the vertically upward direction for removing the support ring 112 and the edge ring 924 from the plasma chamber 1512. The support ring 112 and the edge ring 924 are removed for replacement or maintenance of the support ring 112, or the edge ring 924, or a combination thereof.

On the other hand, when air is supplied to an upper portion of the air cylinder 912, via the air fitting 914A, pressure is created by the air above an upper surface of the piston body 916. Due to the pressure created above the upper surface of the piston body 916, the piston 922 moves in a vertically downward direction, along the y-axis, to pull down the hold down rod 302A. When the hold down rod 302A is pulled down, the support ring 112 is pulled down in the vertically downward direction with respect to the insulator ring 106. Simultaneous with the support ring 112, the edge ring 924 is also pulled down in the vertically downward direction towards the insulator ring 106. The support ring 112 and the edge ring 924 are pulled down towards the insulator ring 106 for and during processing of a substrate placed over the chuck 104.

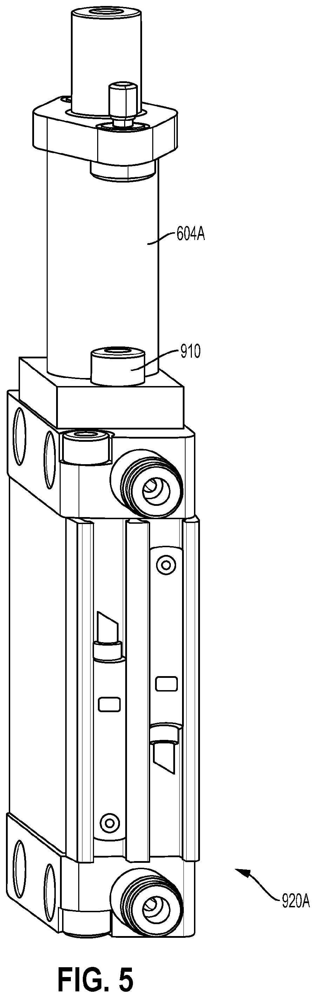

Figure 5 is an isometric view of an embodiment of the clasp mechanism 920A. Shown in Figure 5 is one of the screws 910 and the mount 604A.

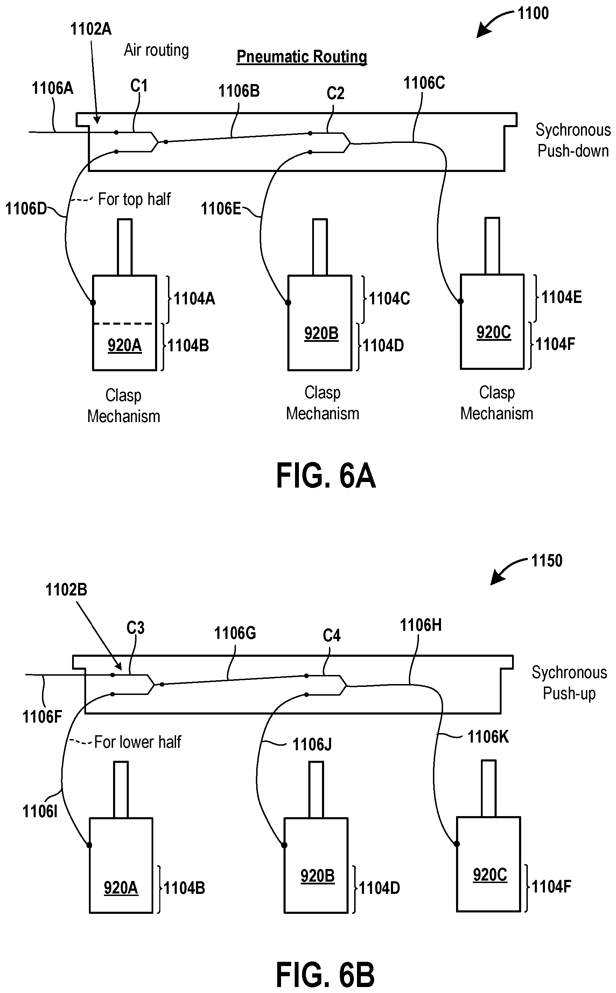

Figure 6A is a diagram of an embodiment of a system 1100 for illustrating a synchronous pull down of the multiple hold down rods 302A and 302B (Figure 3A). The system 1100 includes an air routing 1102A, the clasp mechanism 920A, the clasp mechanism 920B, and the clasp mechanism 920C. The clasp mechanisms 920B and 920C have the same structure and function as the clasp mechanism 920A. As an example, each clasp mechanism 920A through 920C is has a double-acting cylinder. The clasp mechanism 920B is connected to the hold down rod 320B via the mount 604B of figure 6 and the clasp mechanism 920C is connected to the hold down rod 320C via the mount 604C of figure 6.

An air routing, as described herein has multiple tubes, each of which made from the insulator material, such as a combination of plastic and plasticizer, or plastic. The air routing is flexible to be able to connect to the upper portions or the lower portions of the clasp mechanisms 920A-920C.

The air routing 1102A includes multiple tubes 1106A, 1106B, 1106C, 1106D, and 1106E. The tubes 1106A and 1106D are connected to the tube 1106B via connector C1 and the tubes 1106B and 1106E are connected to the tube 1106C via a connector C2. Each connector, described herein, that connects multiple tubes has a hollow space for allowing passage of air via the hollow space. As an example, each connector that connects multiple tubes is made from the insulator material.

The tube 1106D is connected via the air fitting 914A (Figure 4) to an upper portion 1104A of the clasp mechanism 920A. Similarly, the tube 1106E is connected via an air fitting, such as the air fitting 914A, to an upper portion 1104C of the clasp mechanism 920B and the tube 1106C is connected via an air fitting, such as the air fitting 914A, to an upper portion 1104E of the clasp mechanism 920C.

Air is supplied via the tube 1106A, the connector C1, and the tube 1106D to the upper portion 1104A of the clasp mechanism 920A. Similarly, air is supplied via the tube 1106A, the connector C1, the tube 1106B, the connector C2, and the tube 1106E to the upper portion 1104C of the clasp mechanism 920B. Moreover, air is supplied via the tube 1106A, the connector C1, the tube 1106B, the connector C2, and the tube 1106C to the upper portion 1104E of the clasp mechanism 920C. When air is supplied to the upper portions 1104A, 1104C, and 1104E, pistons of the clasp mechanism 920A-920C are pulled down synchronously, such as simultaneously, along the y-axis, to move the support ring 112 (Figure 4) and the edge ring 924 (Figure 4) towards the insulator ring 106 (Figure 4).

There are multiple barrel seals around the power pin 208, the hold down rods 302A and 302B, and a temp probe shaft 1402, described below. These barrel seals exert a force in a vertically upward direction, along the y-axis, on the support ring 112. The clasp mechanisms 920A-920C overcome the up in the vertically upward direction to prevent the support ring 112 from lifting up in the vertical direction with respect to the chuck 104. Moreover, the clasp mechanisms 920A-920C apply a clamp force to the gel layers 110B and 110C (Figures 1 and 2) between the edge ring 924 and the chuck 104. The double-acting cylinder applies a constant force on the support ring 112 in the vertically upward direction or in the vertically downward direction independent of temperature of the support ring 112.

Figure 6B is a diagram of an embodiment of a system 1150 for illustrating asynchronous push up of the multiple hold down rods 302A and 302B (Figure 3A). The system 1150 includes an air routing 1102B, the clasp mechanism 920A, the clasp mechanism 920B, and the clasp mechanism 920C.

The air routing 1102B includes multiple tubes 1106F, 1106G, 1106H, 1106I, 1106J, and 1106K. The tubes 1106F and 1106I are connected to the tube 1106G via connector C3 and the tubes 1106G and 1106J are connected to the tube 1106K via a connector C4. The tube 1106I is connected via the air fitting 914B (Figure 4) to a lower portion 1104B of the clasp mechanism 920A. Similarly, the tube 1106J is connected via an air fitting, such as the air fitting 914B, to a lower portion 1104D of the clasp mechanism 920B and the tube 1106K is connected via an air fitting, such as the air fitting 914B, to a lower portion 1104F of the clasp mechanism 920C.

Air is supplied via the tube 1106F, the connector C3, and the tube 1106I to the lower portion 1104B of the clasp mechanism 920A. Similarly, air is supplied via the tube 1106F, the connector C3, the tube 1106G, the connector C4, and the tube 1106J to the lower portion 1104D of the clasp mechanism 920B. Moreover, air is supplied via the tube 1106F, the connector C3, the tube 1106G, the connector C4, and the tube 1106H to the lower portion 1104F of the clasp mechanism 920C. When air is supplied to the lower portions 1104B, 1104D, and 1104F, pistons of the clasp mechanism 920A-920C are pushed up synchronously, such as simultaneously, along the y-axis, to move the support ring 112 (Figure 4) and the edge ring 924 (Figure 4) away from the insulator ring 112 (Figure 4).

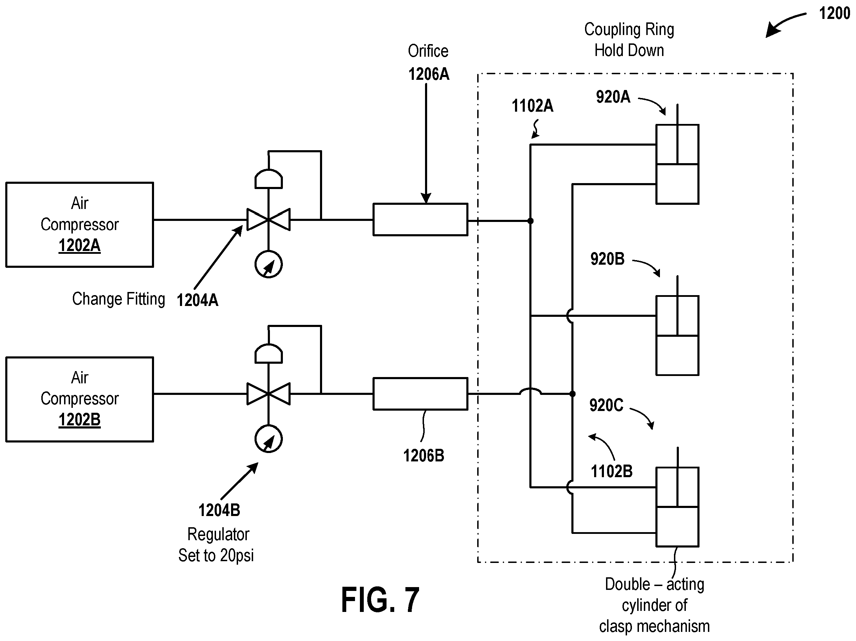

Figure 7 is a block diagram of an embodiment of a system 1200 to illustrate a supply of air to the clasp mechanisms 920A through 920C. The system 1200 includes multiple air compressors 1202A and 1202B, multiple air pressure regulators 1204A and 1204B, multiple orifices 1206A and 1206B, the air routings 1102A and 1102B, and the clasp mechanisms 920A through 920C. The air compressor 1202A is coupled via the regulator 1204A and the orifice 1206A and the air routing 1102A to the upper portions of the clasp mechanisms 920A through 920C. Similarly, the air compressor 1202B is coupled via the regulator 1204B and the orifice 1206B and the air routing 1102B to the lower portions of the clasp mechanisms 920A through 920C.

The air compressor 1202A compresses air to generate compressed air. The compressed air is supplied to the air pressure regulator 1204A. The air pressure regulator 1204A controls, such as changes in pressure of the compressed air to a predetermined air pressure, and supplies the compressed air having the predetermined air pressure via the orifice 1206A and the air routing 1102A to the upper portions of the clasp mechanisms 920A. An example of a predetermined air pressure, described herein, is an air pressure of 190 kPa (28 pounds per square inch (psi)). Other examples of a predetermined air pressure, as described herein, is an air pressure ranging between 170 kPa (25 psi) and 210 kPa (31 psi).

Similarly, the air compressor 1202B compresses air to generate compressed air. The compressed air is supplied to the air pressure regulator 1204B. The air pressure regulator 1204B controls, such as changes in pressure of the compressed air to the predetermined air pressure, and supplies the compressed air having the predetermined air pressure via the orifice 1206B and the air routing 1102B to the lower portions of the clasp mechanisms 920B.

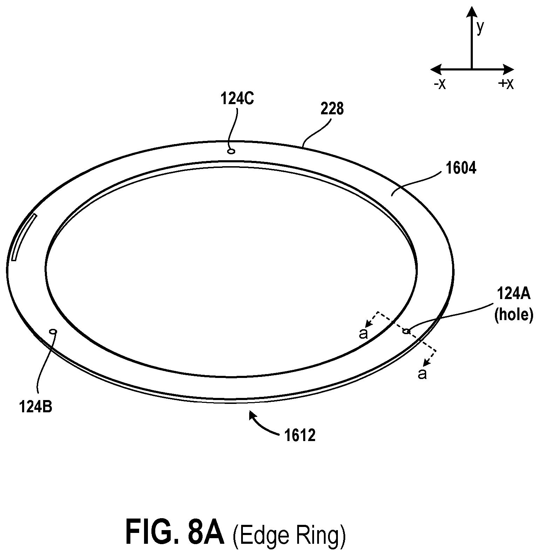

Figure 8A is an isometric view of an embodiment of the edge ring 228. The edge ring 228 has a top surface 1604. Figure 8A illustrates a see-through view of multiple fastener holes 124A, 124B, and 124C formed within a bottom surface 1612 of the edge ring 228.

In some embodiments, any other number of fastener holes, such as six or nine fastener holes, are formed within the bottom surface 1612 for fitting the same number of fasteners within the respective holes. For example, a distance between two adjacent holes of a set formed within the bottom surface 1612 of the edge ring 228 is the same as a distance between two adjacent holes of another set formed within the bottom surface 1612 of the edge ring 228. To illustrate, any one of two adjacent holes of the set is the same as or not the same as one of two adjacent holes of the other set.

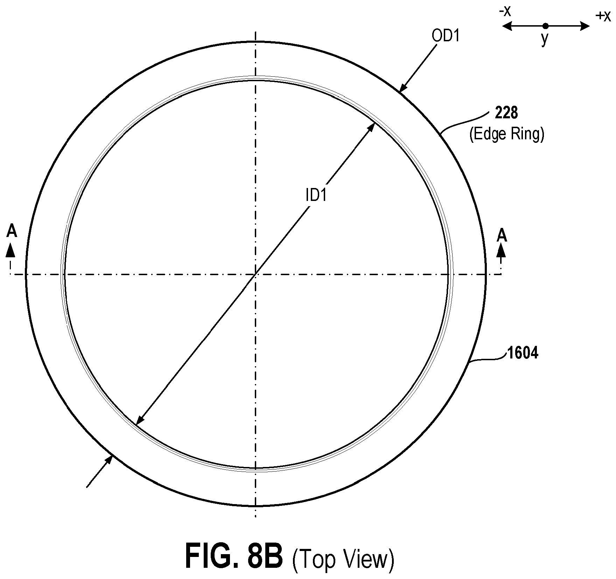

Figure 8B is a top view an embodiment of the edge ring 228. The edge ring 228 has an inner diameter ID1 and an outer diameter OD1. The outer diameter OD1 ranges from and including about 34.5 cm (13.6 inches) to about 38 cm (15 inches). As another example, the diameter OD1 ranges from and including about 34. 5 cm (13.6 inches) to about 41 cm (16 inches). As yet another example, the diameter OD1 ranges from and including about 30 cm (12 inches) to about 46 cm (18 inches). When the outer diameter OD1 exceeds 34.5 cm (13.6 inches), such as is greater than 36 cm (14 inches) or close to 38 cm (15 inches), chances of arcing of RF power between the edge ring 228 and the cover ring 118 are reduced. The inner diameter ID1 is a diameter of an inner peripheral edge of the edge ring 228 and the outer diameter OD1 is a diameter of an outer peripheral edge of the edge ring 228. The top surface 1604 is visible in the top view of the edge ring 228.

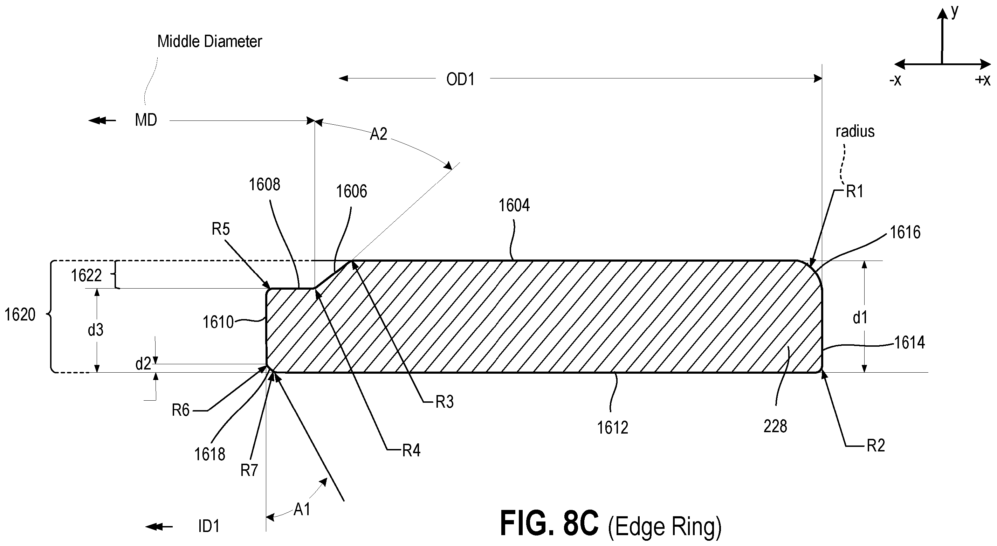

Figure 8C is a cross-sectional view of the edge ring 228 along an A-A cross-section illustrated in Figure 8B. The edge ring 228 has the top surface 1604, sometimes referred to herein as a top side, and the bottom surface 1612, which is sometimes referred to herein as a bottom side. Each of the top surface 1604 and the bottom surface 1612 is a horizontally oriented surface. The edge ring 228 further has an inner surface 1620, sometimes referred to herein as an inner side, and an outer surface 1614, which is sometimes referred to herein as an outer side. The outer surface 1614 is a vertically oriented surface. It should be noted that the edge ring 228 has an annular body, such as a circular body, or ring-shaped body, or dish-shaped body.

The edge ring 228 has a step 1622 that includes an angled inner surface 1606 and a horizontally oriented inner surface 1608. The angled inner surface 1606 forms an angle A2, which is about 15° or about 50°, with respect to a vertically oriented inner surface 1610. In one embodiment, the angle A2 ranges between about 5° and about 55°. In another embodiment, the angle A2 ranges between about 12° and about 20°. °. In yet another embodiment, the angle A2 ranges between about 10° and about 20°. The angled inner surface 1608 is contiguous with the top surface 1604. For example, the angled inner surface 1606 forms a radius R3 with respect to the top surface 1604. To illustrate, the radius R3 is about 0.3 mm (.01 inch) maximum. For example, a curve having the radius R3 is formed between the angled inner surface 1606 and the top surface 1604. As an example, the radius R3 ranges from and including about 0.2 mm (.009 inch) to about 0.28 mm (.011 inch).

The horizontally oriented inner surface 1608 is contiguous with the angled surface 1606. For example, the horizontally oriented inner surface 1608 forms a radius R4 with respect to the angled inner surface 1606. To illustrate, the radius R4 is about 0.81 mm (0.032 inch). For example, a curve having the radius R4 is formed between the horizontally oriented inner surface 1608 and the angled inner surface 1606. As an example, the radius R4 ranges from and including about 0.08 mm (.003 inch) to about 0.086 mm (.0034 inch). A middle diameter (MD) of a location on the edge ring 228 at which the radius R4 is formed is about 30.119 cm (11.858 inches). For example the middle diameter ranges from and including about 30.114 cm (11.856 inches) to about 30.12 cm (11.86 inches).

A horizontally oriented surface, as described herein, is substantially parallel to the x-axis and a vertically oriented surface, as described herein, is substantially parallel to the y-axis. For example, a horizontally oriented surface forms an angle ranging from -5° to +5° with respect to the x-axis and a vertically oriented surface forms an angle ranging from -5° to +5° with respect to the y-axis. To illustrate, a horizontally oriented surface is parallel to the x-axis and perpendicular to the y-axis and a vertically oriented surface is parallel to the y-axis and perpendicular to the x-axis. An angled surface, as described herein, is neither a vertically oriented surface nor a horizontally oriented surface.

The horizontally oriented inner surface 1608 is separated from the top surface 1604 by the angled inner surface 1606. For example, the angled inner surface 1606 is adjacent to the top surface 1604 and to the horizontally oriented inner surface 1608 but the horizontally oriented inner surface 1608 is not adjacent to the top surface 1604.

Moreover, the inner surface 1620 has the vertically oriented inner surface 1610, which is contiguous with the horizontally oriented inner surface 1608. For example, the vertically oriented inner surface 1610 forms a radius R5 with respect to the horizontally oriented inner surface 1608. To illustrate, a curve having the radius R5 is formed between the vertically oriented inner surface 1610 and the horizontally oriented inner surface 1608. As an example, the radius R5 is about 0.30 mm (0.012 inch). To illustrate, the radius R5 ranges from and including about 0.2 mm (.007 inch) to about 0.43 mm (.017 inch). A distance d3 of the vertically oriented inner surface 1610, along the y-axis, is about 0.429 mm (.0169 inch). For example, the distance d3 ranges from and including about 0.417 mm (.0164 inch) to about 0.442 mm (0.0174 inch). A distance of a vertically oriented surface is a length along the y-axis in the vertical direction of the vertically oriented surface. Moreover, a distance of a horizontally oriented surface is a width of the horizontally oriented surface along the x-axis in the horizontal direction. Furthermore, a distance of an angled surface is measured in the vertical direction along the y-axis. The vertically oriented inner surface 1610 has the inner diameter ID1, which is about 29.7 cm (11.7 inches). For example the inner diameter ID1 ranges from and including about 28 cm (11 inches) to about 31.5 cm (12.4 inches).

Furthermore, the inner surface 1620 has an angled inner surface 1618 that is angled with respect to the vertically oriented inner surface 1610 and the bottom surface 1612. The angled inner surface 1618 is contiguous with the vertically oriented inner surface 1610. For example, the angled inner surface 1618 forms a radius R6 with respect to the vertically oriented inner surface 1610. To illustrate, a curve having the radius R6 is formed between the angled inner surface 1618 and the vertically oriented inner surface 1610. As an example, the radius R6 is about 0.38 mm (.015 inch). To illustrate, the radius R6 ranges from and including about 0.378 mm (.0149 inch) to about 0.384 mm (.0151 inch). Moreover, the angled inner surface 1618 is contiguous with the bottom surface 1612. For example, the angled inner surface 1618 forms a radius R7 with respect to the bottom surface 1612. To illustrate, a curve having the radius R7 is formed between the angled inner surface 1618 and the bottom surface 1612. As an example, the radius R7 is about twice the radius R6. To illustrate, the radius R6 ranges from and including about 2 X 0.378 mm (.0149 inch) to about 2 X 0.384 mm (.0151 inch).

The angled inner surface 1618 has a length d2, which is about 0.89 mm (0.035 inch). For example, the length d2 ranges from and including about 0.876 mm (.0345 inch) to about 0.902 mm (.0355 inch). The angled inner surface 1618 forms an angle A1, which is about 30°, with respect to the vertically oriented inner surface 1610. For example, the angle A1 ranges from and including about 28° to about 32°. It should be noted that a combination of the angled inner surface 1606, the horizontally oriented inner surface 1608, the vertically oriented inner surface 1610, and the angled inner surface 1618 is sometimes referred to herein as the inner side of the edge ring 228.

The outer surface 1614 is contiguous with, such as adjacent to or continuous with, the bottom surface 1612. For example, the outer surface 1614 forms a radius R2 with respect to the bottom surface 1612. To illustrate, a curve having the radius R2 is formed between the outer surface 1614 and the bottom surface 1612. As an example, the radius R2 is about 0.30 mm (.012 inch). To illustrate, the radius R2 ranges between 0.302 mm (.0119 inch) and 0.307 mm (.0121 inch).

The edge ring 228 includes a curved edge 1616 that is formed between the top surface 1604 and the outer surface 1614 of the edge ring 228. For example, the curved edge 1616 is adjacent to, such as next to, the top surface 1604 and the outer surface 1614. The curved edge 1616 has a radius R1. As an example, the radius R1 is about 3 mm (.1 inch). To illustrate, the radius R1 ranges between 20 mm (.8 inch) and 3 mm (.12 inch). The curvature of the curved edge 1616 reduces chances of arcing of RF power between the edge ring 228 and the cover ring 201. The arcing occurs when plasma is formed and sustained within the plasma chamber 1512. A sharp edge increases chances of arcing. A distance d1, which is a sum of a vertical distance of a height of the curved edge 1616 along the y-axis and a length of the side surface 1614 along the y-axis, is about 5.8 mm (.23 inch). As an example, the distance d1 ranges from and including about 5.82 mm (0.229 inch) to about 5.87 mm (.231 inch). The outer surface 1614 has the outer diameter OD1, which is about 35.7 cm (14.06 inches), as an example, the outer diameter OD1 ranges between 34.3 cm (13.5 inches) and 36.8 cm (14.5 inches). It should be noted that an inner diameter or an outer diameter or a middle diameter of an edge ring, described herein, is formed with respect to a center axis that passes through a centroid of the edge ring.

It should be noted that an edge ring, described herein, is consumable. For example, an edge ring can wear out after multiple uses of the edge ring for processing the substrate 1518 of figure 15. To illustrate, remnant materials are output after the plasma that is used to process the substrate 1508, and the remnant materials corrode the edge ring. Moreover, the plasma corrodes the edge ring.

In addition, the edge ring is replaceable. For example, after repeated uses of the edge ring, the edge ring is replaced. To illustrate, the edge ring is vertically pushed up away from the insulator ring 106 (Figure 2) using the hold down rods 302A and 302B of figure 3A to be released from the insulator ring 106 of figures 1 and 2. The edge ring is then replaced with another edge ring. The other edge ring is then vertically pulled down towards the insulator ring 106 using the hold down rods 302A- and 302B for processing the substrate 1518 or another substrate.

In some embodiments, each radius R1 through R7 of an edge of the edge ring 228 is greater than about 0.8 mm (0.03 inch) to reduce chances of arcing of RF power towards the edge or away from the edge. To further illustrate, each radius R1 through R7 of the edge of the edge ring 228 ranges from and including about 0.8 mm (0.03 inch) to about 3 mm (0.1 inch) to reduce chances of arcing of RF power towards the edge or away from the edge. It should be noted that in various embodiments, each radius R1 through R7 is greater than a range from and including about 0.3 mm (0.01 inch) to about 0.8 mm (0.03 inch). The radius from and including about 0.3 mm (0.01 inch) to about 0.8 mm (0.03 inch) reduces chances of chipping of an edge of the radius during fabrication of a semiconductor wafer.

In one embodiment, the edge ring 228 has a plurality of edges. The edges that define the edge ring 228, in one embodiment, are rounded. By way of example, the edges having the radiuses RA and RC, of the edge ring 228 are rounded to a radius that is about 0.8 mm (.03 inch) or greater. It has been determined that less rounding of these edges may not suffice to prevent or reduce chances of arcing of RF power when the plasma chamber is in operation. The reduction of chances of arcing, influenced by sharper edges of features within the plasma chamber, may be detrimental to a fabrication process being performed over and on semiconductor wafers. Slight rounding of the edges, e.g. each radius RA and RC less than about 0.8 mm (.03 inch), each radius RA and RC ranging from and including about 0.3 mm (.01 inch) to about 0.8 mm (.03 inch), assists in reducing a possibility of particle generation during fabrication of semiconductor wafers, or chipping of the edges during the fabrication. Thus, although some rounding was performed on surfaces of features, e.g. radiuses RA and RC, disposed within the plasma chamber, this rounding is less than that for preventing or reducing arcing in light of the increased power levels being used in plasma processing operations.

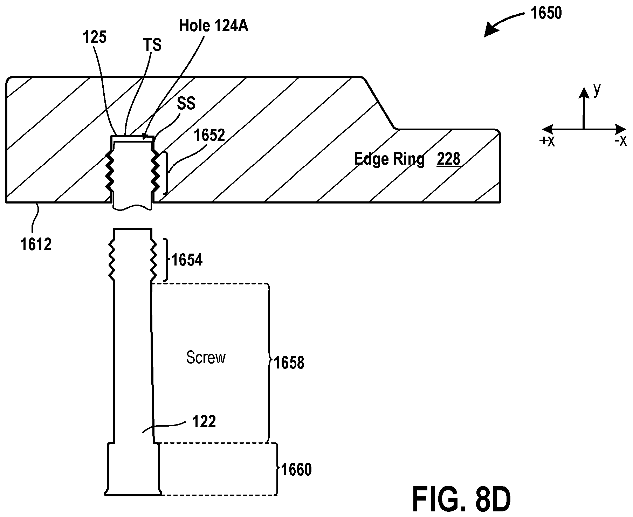

Figure 8D is a diagram of an embodiment of a system 1650 to illustrate a coupling of the fastener 122 to the edge ring 228. A cross-sectional view of the edge ring 228 is taken along a cross-section a-a illustrated in Figure 8A. Drilled within the bottom surface 1612 of the edge ring 228 is the slot 125. In addition to drilling the slot 125, a thread 1652 is formed on the side surface SS of the slot 125. The side surface SS is substantially perpendicular, such as perpendicular to or ranging between 85 and 95°, with respect to the top surface TS of the slot 125. The slot 125 encloses the fastener hole 124A.

The fastener 122 has a thread 1654 formed at a tip of the fastener 122. Moreover, the fastener 122 has a body 1658, which is below the thread 1654. A head 1660 of the fastener 122 is located below the body 1658.

The fastener 122 is inserted into the fastener hole 124A and is turned in a clockwise direction to engage the thread 1654 with the thread 1652 to connect the support ring 112 (Figure 1) with the edge ring 228. Similarly, additional fasteners, such as the fastener 122, are inserted into multiple fastener holes 124B and 124C to connect the support ring 112 with the edge ring 228. The multiple fastener holes 124B and 124C are formed in respective slots within the bottom surface 1612 of the edge ring 228. For example, the fastener holes 124A-124C form vertices of an equilateral triangle within a horizontal plane of the bottom surface 1612 of the edge ring 228. In case more than three fastener holes are formed within the bottom surface 1612, the fastener holes are located at substantially equal, such as equal, distances. For example, a distance between a set of two adjacent fastener holes within the bottom surface 1612 is the same as a distance between another set of two adjacent fastener holes within the bottom surface 1612. A set of two fastener holes is different from another set when at least one of the fastener holes of the set is not the same as one of the fastener holes of the other set. To illustrate, two different sets of fastener holes have at least one uncommon fastener hole. As another example, a distance between two adjacent fastener holes of the set is within a pre-determined limit from a distance between two adjacent fastener holes of the other set within the bottom surface 1612. When the support ring 112 is connected with the edge ring 228 and the edge ring 228 or the support ring 112 is moved, the edge ring 228 and the support ring 112 move simultaneously in a vertical direction along the y-axis or a horizontal direction along the x-axis.

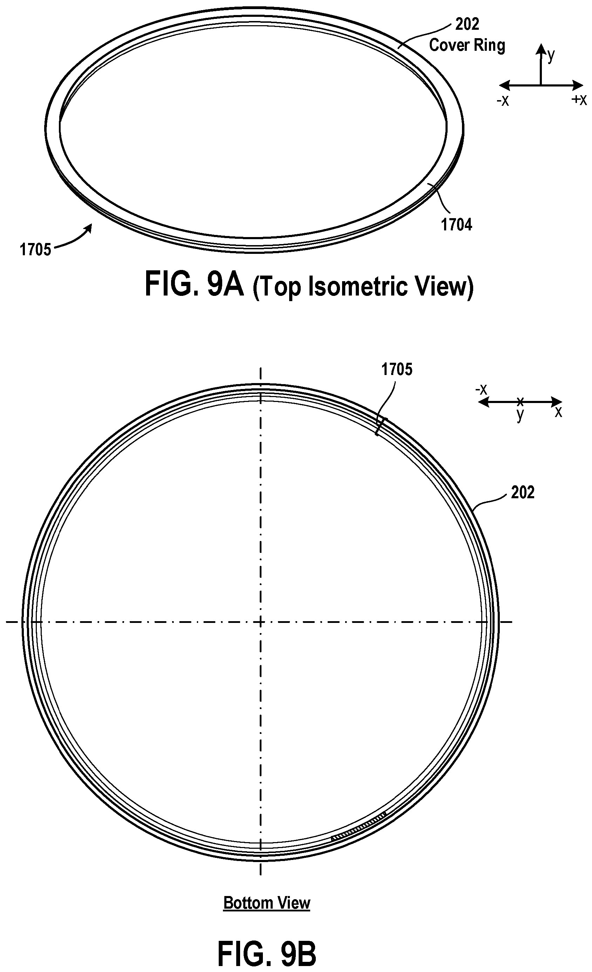

Figure 9A is an isometric view of an embodiment of a cover ring 202. The cover ring 202 is used, in some embodiments, in place of the cover ring 201 of Figure 2. The cover ring 202 has a top surface 1704. It should be noted that a cover ring, described herein, is consumable. For example, a cover ring can wear out after multiple uses of the cover ring during processing the substrate 1518 of figure 15. To illustrate, as a result of processing of the substrate 1508 by plasma, the remnant materials are generated and the remnant materials corrode the cover ring. Moreover, the plasma corrodes the cover ring.

In addition, a cover ring is replaceable. For example, after repeated uses of the cover ring, the cover ring is replaced. To illustrate, the cover ring is removed from the plasma chamber 1512 for replacement with another cover ring.

Figure 9B is a bottom view of an embodiment of the cover ring 202. The cover ring has a bottom surface 1705.

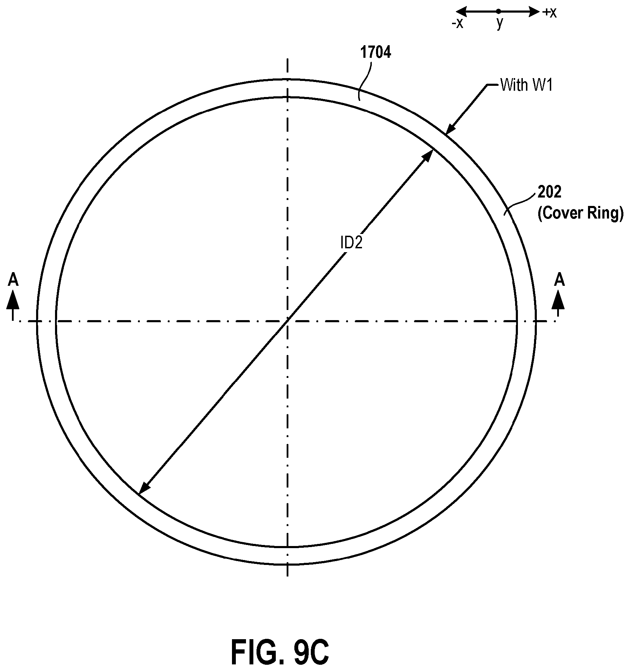

Figure 9C is a top view of an embodiment of the cover ring 202. The cover ring 202 has an inner diameter ID2 and a width W1. The inner diameter ID2 is a diameter of an inner peripheral edge of the cover ring 202. The width W1 is a width of an annular body, of the cover ring 202, between the inner diameter ID1 and an outer diameter of the cover ring 202.

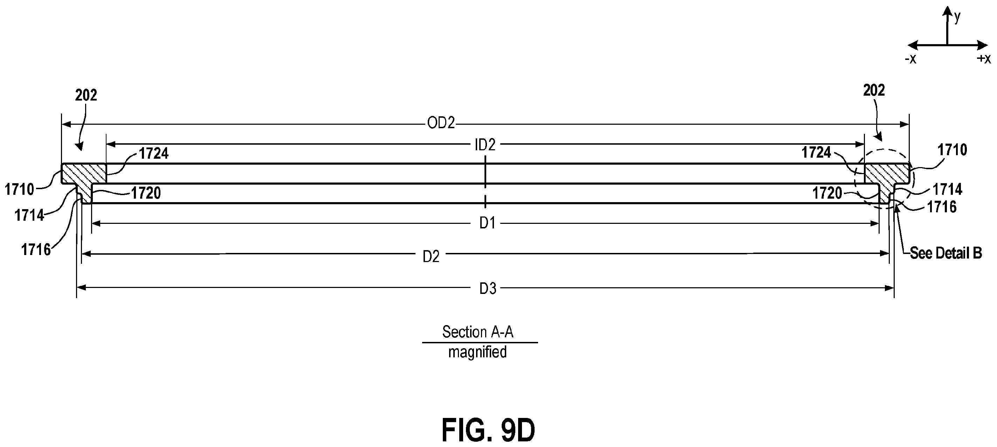

Figure 9D is a cross-sectional view of an embodiment of the cover ring 202 taken along a cross-section A-A of Figure 9C. The cover ring 202 has a vertically oriented inner surface 1724, another vertically oriented inner surface 1720, a vertically oriented outer surface 1716, another vertically oriented outer surface 1714, and a vertically oriented outer surface 1710. A diameter of the vertically oriented inner surface 1724 is ID2. The diameter ID2 is about 34.582 cm (13.615 inches). For example, the diameter ID2 ranges from and including about 34.0 cm (13.4 inches) to about 35.1 cm (13.8 inches). Moreover, a diameter of the vertically oriented inner surface 1720 is D1. The diameter D1 is about 35.33 cm (13.91 inches). For example, the diameter D1 ranges from and including about 35.1 cm (13.8 inches) to about 36 cm (14 inches). Additionally, a diameter of the vertically oriented outer surface 1716 is D2. The diameter D2 is about 36.09 cm (14.21 inches). For example, the diameter D2 ranges from and including about 36 cm (14 inches) to about 36.8 cm (14.5 inches). A diameter of the vertically oriented outer surface 1714 is D3 and a diameter of the vertically oriented outer surface 1710 is OD2. The diameter D3 is about 36.53 cm (14.38 inches). For example, the diameter D3 ranges from and including about 36.1 cm (14.2 inches) to about 36.8 cm (14.5 inches). The diameter OD2 is about 37.3 cm (14.7 inches). For example, the diameter OD2 ranges from and including about 36 cm (14 inches) to about 38 cm (15 inches).

The diameter D1 is greater than the diameter ID2. Moreover, the diameter D2 is greater than the diameter D1 and a diameter D3 is greater than the diameter D2. The diameter OD2 is greater than the diameter D3.

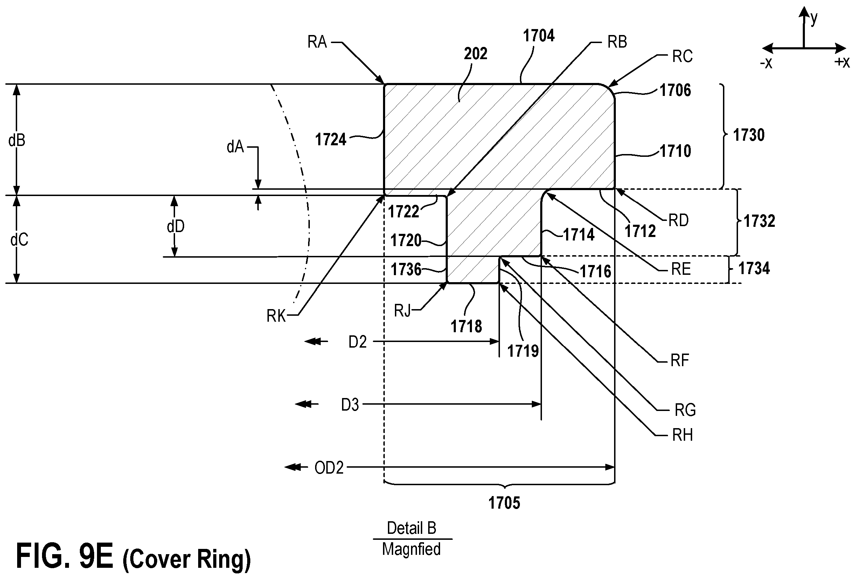

Figure 9E is a cross-sectional view of an embodiment of the cover ring 202. The cover ring 202 includes an upper body portion 1730, a middle body portion 1732, and a lower body portion 1734. The upper body portion 1730 has the vertically oriented outer surface 1710, a horizontally oriented outer surface 1712, another horizontally oriented inner surface 1722, the vertically oriented inner surface 1724, and the top surface 1704, which is horizontally oriented. A curved edge 1706 is formed between the vertically oriented outer surface 1710 and the top surface 1704. The curved edge 1706 has a radius RC, which is about 2 mm (0.06 inch). For example the radius RC ranges from and including about 1.5 mm (0.059 inch) to about 1.5 mm 0.061 inch. The curved edge 1706 is contiguous, such as continuous with or adjacent to, the top surface 1704 and the vertically oriented outer surface 1710.

The vertically oriented outer surface 1710 is contiguous with the horizontally oriented surface 1712. For example, a curve having a radius RD is formed between the vertically oriented outer surface 1710 and the horizontally oriented surface 1712. The radius RD is about 0.38 mm (.015 inch). For example, the radius RD ranges from and including about 0.368 mm (0.0145 inch) to about 0.394 mm (.0155 inch).

Moreover, the horizontally oriented inner surface 1722 is contiguous with the vertically oriented inner surface 1724. For example, a curve having a radius RK is formed between the vertically oriented inner surface 1724 and the horizontally oriented inner surface 1722. To illustrate, the radius RK is about 0.38 mm (.015 inch). As an example, the radius RK ranges from and including about 0.368 mm (.0145 inch) to about 0.394 mm (.0155 inch).

Additionally, the top surface 1704 is contiguous with the vertically oriented inner surface 1724. For example, a curve having a radius RA is formed between the vertically oriented inner surface 1724 and the top surface 1704. To illustrate, the radius RA is about 0.38 mm (.015 inch). As an example, the radius RA ranges from and including about 0.368 mm (.0145 inch) to about 0.394 mm (.0155 inch). The radius RA reduces chances of arcing of RF power between the cover ring 202 and the edge ring 228. The arcing occurs during a time plasma is formed within the plasma chamber 1512.

The middle body portion 1732 includes the vertically oriented inner surface 1720, the vertically oriented outer surface 1714, and a horizontally oriented outer surface 1716. The vertically oriented outer surface 1714 is contiguous with the horizontally oriented outer surface 1712 of the upper body portion 1730. For example, a curve having a radius RE is formed between the vertically oriented outer surface 1714 and the horizontally oriented outer surface 1712. As an example, the radius RE is about 0.8 mm (.03 inch). To illustrate, the radius RE ranges from and including about 0.74 mm (.029 inch) to about 7.9 mm (.31 inch).

Moreover, the vertically oriented inner surface 1720 is contiguous with the horizontally oriented inner surface 1722 of the upper body portion 1730. For example, a curve having a radius RB is formed between the horizontally oriented inner surface 1722 and the vertically oriented inner surface 1720. As an example, the radius RB is about 0.3 mm (.01 inch). To illustrate, the radius RB ranges from and including about 2 mm (.09 inch) to about 0.28 mm (.011 inch).

The horizontally oriented outer surface 1716 is contiguous with the vertically oriented outer surface 1714. For example, a curve having a radius RF is formed between the horizontally oriented outer surface 1716 and the vertically oriented outer surface 1714. As an example, the radius RF is about 0.38 mm (.015 inch). To illustrate, the radius RF ranges from and including about 0.368 mm (.0145 inch) to about 0.394 mm (.0155 inch).

The lower body portion 1734 includes a vertically oriented inner surface 1736, a bottom surface 1718, and a vertically oriented outer surface 1719. The vertically oriented inner surface 1736 is contiguous with the vertically oriented inner surface 1720 of the middle body portion 1732. For example, the vertically oriented inner surfaces 1720 and 1736 are integrated as one surface and have the same diameter D1 (Figure 9D). The vertically oriented inner surface 1736 is contiguous with the bottom surface 1718. For example, a curve having a radius RJ is formed between the vertically oriented inner surface 1736 and the bottom surface 1718. As an example, the radius RJ is about 0.5 mm (.02 inch). To illustrate, the radius RJ ranges from and including about 0.48 mm (.019 inch) to about 0.53 mm (.021 inch).

The vertically oriented outer surface 1719 is contiguous with the bottom surface 1718. For example a curve having a radius RH is formed between the bottom surface 1718 and the vertically oriented outer surface 1719. As an example, the radius RH is about 0.5 mm (.02 inch). To illustrate, the radius RH ranges from and including about 0.48 mm (.019 inch) to about 0.53 mm (.021 inch).

The vertically oriented outer surface 1719 is contiguous with the horizontally oriented outer surface 1716 of the middle body portion 1732. For example, a curve having a radius RG is formed between the vertically oriented outer surface 1719 and the horizontally oriented outer surface 1716. As an example, the radius RG is about 0.3 mm (.01 inch). To illustrate, the radius RG ranges from and including about 2 mm (.09 inch) to about 0.28 mm (.011 inch).

A vertical distance dB, such as a distance along the y-axis, is formed between the horizontally oriented inner surface 1722 and the top surface 1704. As an example, the vertical distance dB is about 6.9 mm (.27 inch). To illustrate, the vertical distance dB ranges from and including about 6.4 mm (.25 inch) to about 7.4 mm (.29 inch).

Moreover, a vertical distance dA is formed between the horizontally oriented outer surface 1712 and the horizontally oriented inner surface 1722. As an example, the distance dA is about 0.28 mm (.011 inch). To illustrate, the distance dA ranges from and including about 0.2 mm (.009 inch) to about 0.33 mm (.013 inch).

Additionally, a vertical distance between the horizontally oriented inner surface 1722 and the horizontally oriented outer surface 1716 is dD. As an example, the distance dD is about 4.37 mm (.172 inch). To illustrate, the distance dD ranges from and including about 4.3 mm (.17 inch) to about 4.42 mm (.174 inch).

Also, a vertical distance between the horizontally oriented inner surface 1722 and the bottom surface 1718, which is horizontally oriented, is represented as dC. As an example, the distance dC is about 6.78 mm (.267 inch). To illustrate, the distance dC ranges from and including about 6.73 mm (.265 inch) to about 6.83 mm (.269 inch).

It should be noted that the bottom surface 1705 of the cover ring 202 includes the horizontally oriented inner surface 1722, the vertically oriented inner surfaces 1720 and 1736, the bottom surface 1718, the vertically oriented outer surface 1719, the horizontally oriented outer surface 1716, the vertically oriented outer surface 1714, and the horizontally oriented outer surface 1712.

It should further be noted that all edges of the cover ring 202 are arced, such as curved. For example, the radiuses RA, RB, RC, RD, RE, RF, RG, RH, RJ, and RK define the edges that are arced.

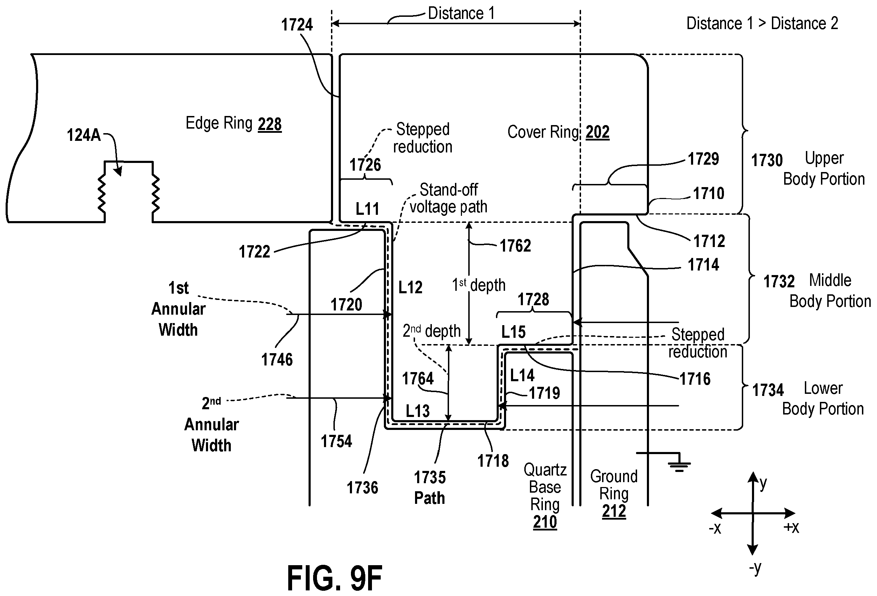

Figure 9F is a cross-sectional view of an embodiment of a system that includes the edge ring 228, the cover ring 202, the base ring 210, and the ground ring 212. A step reduction 1726, which includes a change in direction from the vertically oriented inner surface 1724 to the vertically oriented inner surface 1720 is formed. The step reduction 1726 is in a horizontal direction, such as a +x or x direction, along the x-axis. The step reduction 1726 is between the upper body portion 1730 and the middle body portion 1732. The step reduction 1726 is in the +x direction away from the edge ring 228.

Moreover, another step reduction 1729 that occurs from the vertically oriented outer surface 1710 to the vertically oriented outer surface 1714 is formed. Again the step reduction 1729 is in a horizontal direction, such as a -x direction of the x-axis, except that the step reduction 1729 is in a direction opposite that of the step reduction 1726. The step reduction 1729 is in a direction towards the edge ring 228.

A depth 1762, which is a distance from the horizontally oriented inner surface 1722 to the horizontally oriented outer surface 1716, of the middle body portion 1732 is formed. A depth, as used herein, is in a direction, such as a -y direction, of the y-axis.

In addition, another step reduction 1728 is formed from the vertically oriented outer surface 1714 to the vertically oriented outer surface 1719. The step reduction 1728 is in the -x direction.

Another depth 1764 is formed between the horizontally oriented outer surface 1716 and the bottom surface 1718 of the lower body portion 1734. The depth 1764 is of the lower body portion 1734. It should be noted that the depth 1764 is less than the depth 1762. Moreover, a depth of the vertically oriented inner surface 1724 is greater than the depth 1762.

An annular width 1746 is created between the vertically oriented inner surface 1720 and the vertically oriented outer surface 1714. An annular width, as used herein, is along the x-axis. Moreover, another annular width 1754 is created between the vertically oriented inner surface 1736 and the vertically oriented outer surface 1719. The annular width 1754 is less than annular width 1746.

A tracking distance 1735 is between the edge ring 228 and the ground ring 212. The tracking distance 1735 is along a width L11 of the horizontally oriented inner surface 1722, a combined length L12 of the vertically oriented inner surfaces 1720 and 1736, a width L13 of the bottom surface 1718, a length L14 of the vertically oriented outer surface 1719, and a width L15 of the horizontally oriented outer surface 1716. The combined length L12 is a sum of a length of the vertically oriented inner surface 1720 and a length of the vertically oriented inner surface 1736. The tracking distance 1735 is a path along which voltage received from the RF power pin 208 is dissipated along the cover ring 202. The edge ring 228 acts as a capacitor plate of a capacitor and the electrode EL (Figure 2) acts as another capacitor plate of the capacitor with a dielectric material of the support ring 112 in between the two capacitor plates. A distance 1 is a horizontal distance, along the x-axis, between the edge ring 228 and the ground ring 212 for the voltage provided by the RF power pin 208 to dissipate.

The tracking distance 1735 or the distance 1 defines an annular width of the cover ring 202. Moreover, voltage dissipation along the tracking distance 1735 or the distance 1 defines the annular width of the cover ring 202. The annular width of the cover ring 202 is a difference between the inner diameter ID2 of the cover ring 202 and the outer diameter OD2 of the cover ring 202. The annular width of the cover ring 202 is defined such that the pre-determined amount of stand-off voltage is achieved at the vertically oriented inner surface 1724. For example, given that 7-10 volts is dissipated along 3 hundredths of a mm (a thousandth of an inch) of the cover ring 202 and the stand-off voltage at the vertically oriented inner surface 1724 is 5000 volts, the annular width of the cover ring 202 is equal to a ratio of a multiple, such as two or three, of 5000 volts and the dissipation of 7-10 volts per 3 hundredths of a mm (thousandth of an inch) of the cover ring 202.

In some embodiments, the depth 1764 is greater than the depth 1762. Moreover, in various embodiments, the depth of the vertically oriented inner surface 1724 is less than the depth 1762.

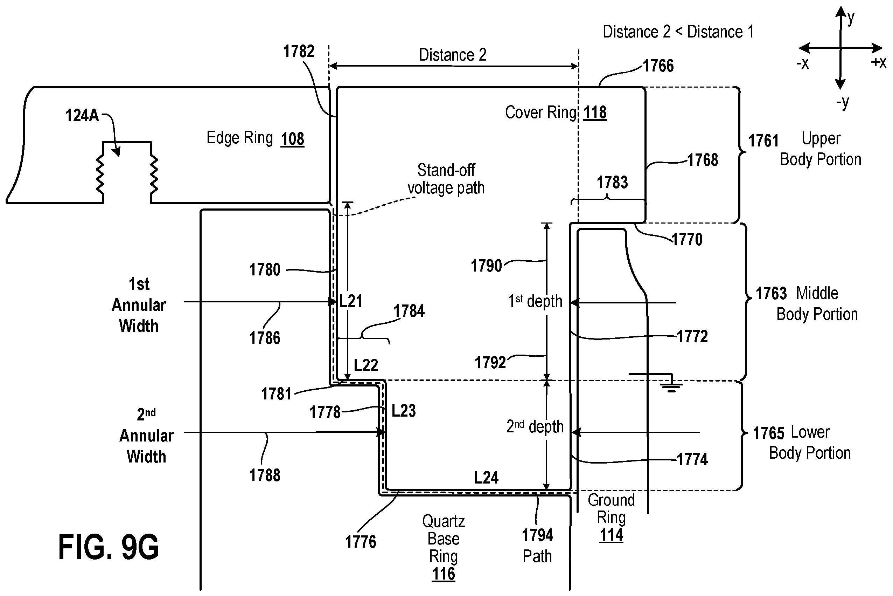

Figure 9G is a cross-sectional view of an embodiment of a system that includes the edge ring 108, the cover ring 118, the base ring 116, and the ground ring 114. The cover ring 118 includes an upper body portion 1761, a middle body portion 1763, and a lower body portion 1765.

The upper body portion 1761 includes a vertically oriented inner surface 1782, a horizontally oriented top surface 1766, a vertically oriented outer surface 1768, and a horizontally oriented outer surface 1770. The vertically oriented outer surface 1768 is contiguous with the top surface 1766 and the horizontally oriented outer surface 1770 is contiguous with the vertically oriented outer surface 1768. For example, a curve having a radius is formed between the vertically oriented outer surface 1768 and the top surface 1766 and a curve having a radius is formed between the horizontally oriented outer surface 1770 and the vertically oriented outer surface 1768. Moreover, the vertically oriented inner surface 1782 is contiguous with the top surface 1766. For example, a curve having a radius is formed between the vertically oriented inner surface 1782 and the top surface 1766.

The middle body portion 1763 includes a vertically oriented outer surface 1772, a vertically oriented inner surface 1780, and a horizontally oriented inner surface 1781. The vertically oriented outer surface 1772 is contiguous with the horizontally oriented outer surface 1770 of the upper body portion 1761. For example, a curve having a radius is formed between the vertically oriented outer surface 1772 and the horizontally oriented outer surface 1770.

Moreover, the vertically oriented inner surface 1780 is contiguous with, such as adjacent to, the vertically oriented inner surface 1782. To illustrate, the vertically oriented inner surface 1782 lies in the same vertical plane as that of the vertically oriented inner surface 1782.

The horizontally oriented inner surface 1781 is contiguous with the vertically oriented inner surface 1780. For example, a curve having a radius is formed between the horizontally oriented inner surface 1781 and the vertically oriented inner surface 1780.

The lower body portion 1765 includes a vertically oriented outer surface 1774, a horizontally oriented bottom surface 1776 and a vertically oriented inner surface 1778. The vertically oriented inner surface 1778 is contiguous with the horizontally oriented inner surface 1781 of the middle body portion 1763. For example, a curve having a radius is formed between the vertically oriented inner surface 1778 and the horizontally oriented inner surface 1781.

Moreover, the bottom surface 1776 is contiguous with the vertically oriented inner surface 1778. For example, a curve having a radius is formed between the bottom surface 1776 and the vertically oriented inner surface 1778.

Also, the bottom surface 1776 is contiguous with the vertically oriented outer surface 1774. For example, a curve having a radius is formed between the bottom surface 1776 and the vertically oriented outer surface 1774. The vertically oriented outer surface 1774 lies in the same vertical plane as that of the vertically oriented outer surface 1772 of the middle body portion 1763.

A step reduction 1783 is formed between the vertically oriented outer surface 1768 of the upper body portion 1761 and the vertically oriented outer surface 1772 of the middle body portion 1763. The step reduction 1783 is in the -x direction towards the edge ring 108.

Moreover, another step reduction 1784 is formed from the vertically oriented inner surface 1780 of the middle body portion 1763 to the vertically oriented inner surface 1778 of the lower body portion 1765. The step reduction 1784 from the vertically oriented inner surface 1780 occurs in the +x direction, of the x-axis, away from the edge ring 108.

An annular width 1786 is formed between the vertically oriented inner surface 1780 and the vertically oriented outer surface 1772 of the middle body portion 1760. The annular width 1786 is along the x-axis. Moreover, another annular width 1788 is formed between the vertically oriented inner surface 1778 and the vertically oriented outer surface 1774 of the lower body portion 1765. The annular width 1788 is along the x-axis. The annular width 1788 is less than the annular width 1786.

A depth 1790, along the y-axis, of the middle body portion 1763 is formed from the horizontally oriented outer surface 1770 to the horizontally oriented inner surface 1781. Moreover, another depth 1792, along the y-axis, of the lower body portion 1765 is formed from the horizontally oriented inner surface 1781 to the bottom surface 1776. The depth 1792 is less than the depth 1790.

It should be noted that a bottom surface of the cover ring 118 includes the surfaces 1781, 1778, 1776, 1774, 1772, and 1770.

The tracking distance 1794 is formed between the edge ring 108 and the ground ring 114. The tracking distance 1794 is along a depth L21, along the y-axis, of the vertically oriented inner surface 1780, a width L22, along the x-axis, of the horizontally oriented inner surface 1781, a depth L23 of the vertically oriented inner surface 1778, and a width L24 of the bottom surface 1776. The depth L23 is the same as the depth 1792. The tracking distance 1794 is a path along which voltage received by the edge ring 108 via the support ring 112 reaches the ground ring 114. The edge ring 108 acts as a capacitor plate of a capacitor and the electrode EL (Figure 2) acts as another capacitor plate of the capacitor with a dielectric material of the support ring 112 in between the two capacitor plates.

A distance 2, along the x-axis, is formed between the edge ring 108 and the ground ring 114. The distance 2 is less than the distance 1 of Figure 9F. Because the outer diameter of the edge ring 228 of Figure 9F is less than the outer diameter of the edge ring 108, the upper body portion 1730 of the cover ring 202 of Figure 9F has a greater width then the upper body portion 1761 of the cover ring 118. The increase in the width of the upper body portion 1730 compared to the width of the upper body portion 1761 increases the distance 1 compared to the distance 2. The greater distance 1 compensates for the reduced width of the edge ring 228 compared to the edge ring 108 to provide a predetermined amount of distance for an RF voltage of an RF signal that is supplied by the power pin 208 (Figure 2) to traverse via the tracking distance 213 (Figure 2) or 1735 (Figure 9F) to the ground ring 212. For example, there is a loss of about 7 to about 10 volts per 3 hundredths of a mm (thousandth of an inch) of a cover ring. If the pre-determined stand-off voltage of 5000 V is to be achieved at a vertically oriented inner surface of an upper body portion of the cover ring, an annular width of the upper body portion of the cover ring is calculated to be (positive real number X 5000)/(loss in volts per 3 hundredths of a mm (thousandth inch) of the cover ring), where "positive real number" is a multiple, such as 2 or 3 or 4.

In some embodiments, the depth 1792 is greater than the depth 1790.

Embodiments described herein may be practiced with various computer system configurations including hand-held hardware units, microprocessor systems, microprocessor-based or programmable consumer electronics, minicomputers, mainframe computers and the like. The embodiments can also be practiced in distributed computing environments where tasks are performed by remote processing hardware units that are linked through a network.

In some embodiments, a controller, described herein, is part of a system, which may be part of the above-described examples. Such systems include semiconductor processing equipment, including a processing tool or tools, chamber or chambers, a platform or platforms for processing, and/or specific processing components (a wafer pedestal, a gas flow system, etc.). These systems are integrated with electronics for controlling their operation before, during, and after processing of a semiconductor wafer or substrate. The electronics is referred to as the "controller," which may control various components or subparts of the system or systems. The controller, depending on the processing requirements and/or the type of system, is programmed to control any of the processes disclosed herein, including the delivery of process gases, temperature settings (e.g., heating and/or cooling), pressure settings, vacuum settings, power settings, RF generator settings, RF matching circuit settings, frequency settings, flow rate settings, fluid delivery settings, positional and operation settings, wafer transfers into and out of a tool and other transfer tools and/or load locks coupled to or interfaced with a system.

Broadly speaking, in a variety of embodiments, the controller is defined as electronics having various integrated circuits, logic, memory, and/or software that receive instructions, issue instructions, control operation, enable cleaning operations, enable endpoint measurements, and the like. The integrated circuits include chips in the form of firmware that store program instructions, digital signal processors (DSPs), chips defined as ASICs, PLDs, and/or one or more microprocessors, or microcontrollers that execute program instructions (e.g., software). The program instructions are instructions communicated to the controller in the form of various individual settings (or program files), defining the parameters, the factors, the variables, etc., for carrying out a particular process on or for a semiconductor wafer or to a system. The program instructions are, in some embodiments, a part of a recipe defined by process engineers to accomplish one or more processing steps during the fabrication of one or more layers, materials, metals, oxides, silicon, silicon dioxide, surfaces, circuits, and/or dies of a wafer.

The controller, in some embodiments, is a part of or coupled to a computer that is integrated with, coupled to the system, otherwise networked to the system, or a combination thereof. For example, the controller is in a "cloud" or all or a part of a fab host computer system, which allows for remote access of the wafer processing. The computer enables remote access to the system to monitor current progress of fabrication operations, examines a history of past fabrication operations, examines trends or performance metrics from a plurality of fabrication operations, to change parameters of current processing, to set processing steps to follow a current processing, or to 17D a new process.

In some embodiments, a remote computer (e.g. a server) provides process recipes to a system over a network, which includes a local network or the Internet. The remote computer includes a user interface that enables entry or programming of parameters and/or settings, which are then communicated to the system from the remote computer. In some examples, the controller receives instructions in the form of data, which specify the parameters, factors, and/or variables for each of the processing steps to be performed during one or more operations. It should be understood that the parameters, factors, and/or variables are specific to the type of process to be performed and the type of tool that the controller is configured to interface with or control. Thus as described above, the controller is distributed, such as by including one or more discrete controllers that are networked together and working towards a common purpose, such as the processes and controls described herein. An example of a distributed controller for such purposes includes one or more integrated circuits on a chamber in communication with one or more integrated circuits located remotely (such as at the platform level or as part of a remote computer) that combine to control a process on the chamber.

Without limitation, in various embodiments, example systems to which the methods are applied include a plasma etch chamber or module, a deposition chamber or module, a spin-rinse chamber or module, a metal plating chamber or module, a clean chamber or module, a bevel edge etch chamber or module, a physical vapor deposition (PVD) chamber or module, a chemical vapor deposition (CVD) chamber or module, an atomic layer deposition (ALD) chamber or module, an atomic layer etch (ALE) chamber or module, a plasma-enhanced chemical vapor deposition (PECVD) chamber or module, a clean type chamber or module, an ion implantation chamber or module, a track chamber or module, and any other semiconductor processing systems that is associated or used in the fabrication and/or manufacturing of semiconductor wafers.

It is further noted that in some embodiments, the above-described operations apply to several types of plasma chambers, e.g., a plasma chamber including an inductively coupled plasma (ICP) reactor, a transformer coupled plasma chamber, conductor tools, dielectric tools, a plasma chamber including an electron cyclotron resonance (ECR) reactor, etc. For example, one or more RF generators are coupled to an inductor within the ICP reactor. Examples of a shape of the inductor include a solenoid, a dome-shaped coil, a flat-shaped coil, etc.

As noted above, depending on the process step or steps to be performed by the tool, the host computer communicates with one or more of other tool circuits or modules, other tool components, cluster tools, other tool interfaces, adjacent tools, neighboring tools, tools located throughout a factory, a main computer, another controller, or tools used in material transport that bring containers of wafers to and from tool locations and/or load ports in a semiconductor manufacturing factory.

With the above embodiments in mind, it should be understood that some of the embodiments employ various computer-implemented operations involving data stored in computer systems. These operations are those physically manipulating physical quantities. Any of the operations described herein that form part of the embodiments are useful machine operations.

Some of the embodiments also relate to a hardware unit or an apparatus for performing these operations. The apparatus is specially constructed for a special purpose computer. When defined as a special purpose computer, the computer performs other processing, program execution or routines that are not part of the special purpose, while still being capable of operating for the special purpose.

In some embodiments, the operations may be processed by a computer selectively activated or configured by one or more computer programs stored in a computer memory, cache, or obtained over the computer network. When data is obtained over the computer network, the data may be processed by other computers on the computer network, e.g., a cloud of computing resources.

One or more embodiments can also be fabricated as computer-readable code on a non-transitory computer-readable medium. The non-transitory computer-readable medium is any data storage hardware unit, e.g., a memory device, etc., that stores data, which is thereafter be read by a computer system. Examples of the non-transitory computer-readable medium include hard drives, network attached storage (NAS), ROM, RAM, compact disc-ROMs (CD-ROMs), CD-recordables (CD-Rs), CD-rewritables (CD-RWs), magnetic tapes and other optical and non-optical data storage hardware units. In some embodiments, the non-transitory computer-readable medium includes a computer-readable tangible medium distributed over a network-coupled computer system so that the computer-readable code is stored and executed in a distributed fashion.

Although the method operations above were described in a specific order, it should be understood that in various embodiments, other housekeeping operations are performed in between operations, or the method operations are adjusted so that they occur at slightly different times, or are distributed in a system which allows the occurrence of the method operations at various intervals, or are performed in a different order than that described above.

It should further be noted that in an embodiment, one or more features from any embodiment described above are combined with one or more features of any other embodiment without departing from a scope described in various embodiments described in the present disclosure.

Although the foregoing embodiments have been described in some detail for purposes of clarity of understanding, it will be apparent that certain changes and modifications can be practiced within the scope of appended claims. Accordingly, the present embodiments are to be considered as illustrative and not restrictive, and the embodiments are not to be limited to the details given herein.

## Claims

1. An edge ring for use in a plasma processing chamber, the edge ring (108, 1650) having an annular body that is configured to surround a substrate support (104) of the plasma processing chamber, comprising:
the annular body having a bottom side (1612), a top side (1604), an inner side (1620), and an outer side (1614), wherein the annular body is made of a conductive material;
a plurality of threaded holes (124A, 124B, 124C) formed within the annular body along the bottom side, wherein each of the plurality of threaded holes extends from a horizontally oriented surface of the bottom side towards the top side, wherein each of the plurality of threaded holes is partially enclosed by a top surface (TS) of a slot (125) formed within the bottom side of the edge ring and a side surface (SS) of the slot (125), wherein the side surface is substantially perpendicular with respect to the top surface, wherein the horizontally oriented surface contiguously extends from a vertically oriented inner surface (1610) of the inner side to the plurality of threaded holes, wherein each of the plurality of threaded holes has a threaded inner surface (1652) on the side surface of the slot (125) for receiving a fastener (122) that extends from a support ring (112) located below the annular body, wherein the fastener extends towards the annular body for attaching the annular body to the support ring;
a step disposed at the inner side of the annular body, the step having a lower surface (1608) separated from the top side by an angled surface (1606); and
one or more curved edges.

2. The edge ring of claim 1, wherein the edge ring is consumable and replaceable.

3. The edge ring of claim 1, wherein the one or more curved edges comprise a curved edge (1616) formed between the top side and the outer side,
wherein the inner side has the angled surface (1606), a horizontally oriented surface (1608) contiguous with the angled surface, and the vertically oriented inner surface (1610) contiguous with the horizontally oriented surface of the inner side,
wherein the bottom side is horizontally oriented and contiguous with the outer side and the vertically oriented inner surface,
wherein the outer side is a vertically oriented outer surface,
wherein the curved edge is adjacent to the top side and to the outer side.

4. The edge ring of claim 1, wherein the plurality of threaded holes are spaced at equal distances on the bottom side.

5. The edge ring of claim 1, wherein a gap (Gap 1) between the top surface of the slot and one of the fasteners when received in the slot is less than one millimeter to reduce chances of arcing in the gap.

6. The edge ring of claim 1, wherein the annular body has an outer diameter ranging from and including about 34.5 cm (13.6 inches) to about 38 cm (15 inches), wherein the outer diameter is limited by the outer side.

7. The edge ring of claim 1, wherein the one or more curved edges comprise a curved edge (1616) formed between the top side and the outer side, wherein the curved edge is configured to reduce
chances of arcing from the curved edge to a cover ring (118) when placed adjacent to the outer side; or
wherein the top side has an outer diameter greater than 34.5 cm (13.6 inches) and at most 38 cm (15 inches) to reduce chances of arcing from the top side to a cover ring (118) when placed adjacent to the outer side; or
wherein all edges of the edge ring are arced.

8. A system for securing an edge ring (108, 1650) of a plasma chamber, comprising:
the edge ring;
an insulator ring (106);
a support ring (112) located below the edge ring and above the insulator ring;
a gel layer (110A, 110B) disposed between a bottom surface (1612) of the edge ring and a top surface of the support ring;
a plurality of screws (122) configured to secure the edge ring to the support ring, each of the plurality of screws attached to a respective one of a plurality of screw holes (124A, 124B, 124C) disposed in the bottom surface of the edge ring and passing through the support ring;
a plurality of hold down rods (302A, 302B) having a plurality of threads to engage with a plurality of threads formed within a bottom surface of the support ring; and
a plurality of pneumatic pistons (922), wherein each of the plurality of pneumatic pistons is coupled to a respective one of the plurality of hold down rods, wherein the plurality of pneumatic pistons are configured to apply a pull down force on the plurality of hold down rods to simultaneously secure the edge ring and the support ring to the insulator ring, wherein the edge ring and the support ring are simultaneously secured to the insulator ring to process a substrate within the plasma chamber.

9. The system of claim 8, wherein the plurality of pneumatic pistons are configured to push up the plurality of hold down rods to remove the edge ring and the support ring from the plasma chamber for maintenance.

10. The system of claim 8, the system further comprising:
a plurality of clasp mechanisms (920A, 920B, 920C) configured to have the plurality of hold down rods, wherein each of the plurality of hold down rods has a portion that extends within the support ring and a portion that extends within the insulator ring, wherein each of the plurality of clasp mechanisms is configured to pull down a respective one of the plurality of hold down rods to engage the support ring and the edge ring with the insulator ring during a processing operation in the plasma chamber and to push up the support ring and the edge ring with respect to the insulator ring to release the support ring and the edge ring.

11. The system of claim 10, wherein each of the plurality of clasp mechanisms includes:
an air cylinder (912);
a piston body (906) within the air cylinder;
a piston rod (916) attached to the piston body; and
a mount (604A) configured to mount a respective one of the plurality of hold down rods with respect to the air cylinder,
an air routing (1102A) configured to supply compressed air to top portions of the air cylinders to pull down the plurality of hold down rods; and
an air routing (1102B) configured to supply compressed air to bottom portions of the air cylinders to push up the plurality of hold down rods.

12. The system of claim 8, wherein a first one of the plurality of pneumatic pistons is a part of a first clasp mechanism (920A), wherein a second one of the plurality of pneumatic pistons is a part of a second clasp mechanism (920B), wherein a third one of the plurality of pneumatic pistons is a part of a third clasp mechanism (920C), the system further comprising:
the second clasp mechanism configured to secure the support ring and the edge ring to the insulator ring at a different location compared to a location at which the first clasp mechanism secures the support ring and the edge ring to the insulator ring;
the third clasp mechanism configured to secure the support ring and the edge ring to the insulator ring at a different location compared to the location at which the second clasp mechanism secures the support ring and the edge ring to the insulator ring and the location at which the first clasp mechanism secures the support ring and the edge ring to the insulator ring.

## Patentansprüche

1. Kantenring zur Verwendung in einer Plasmabehandlungskammer, wobei der Kantenring (108, 1650) einen Ringkörper aufweist, der dazu ausgelegt ist, einen Substratträger (104) der Plasmabehandlungskammer zu umgeben, umfassend:
den Ringkörper, der eine Bodenseite (1612), eine Oberseite (1604), eine Innenseite (1620) und eine Außenseite (1614) aufweist, wobei der Ringkörper aus einem leitfähigen Material besteht;
eine Vielzahl von Gewindelöchern (124A, 124B, 124C), die innerhalb des Ringkörpers entlang der Bodenseite ausgebildet sind, wobei jedes aus der Vielzahl von Gewindelöchern sich von einer horizontal ausgerichteten Fläche der Bodenseite in Richtung der Oberseite erstreckt, wobei jedes aus der Vielzahl von Gewindelöchern teilweise durch eine obere Fläche (TS) eines Schlitzes (125), der innerhalb der Bodenseite des Kantenrings ausgebildet ist, und einer Seitenfläche (SS) des Schlitzes (125) umschlossen ist, wobei die Seitenfläche im Wesentlichen senkrecht bezogen auf die obere Fläche ist, wobei die horizontal ausgerichtete Fläche sich angrenzend von einer vertikal ausgerichteten Innenfläche (1610) der Innenseite bis zur Vielzahl von Gewindelöchern erstreckt, wobei jedes aus der Vielzahl von Gewindelöchern eine mit Gewinde versehene Innenfläche (1652) auf der Seitenfläche des Schlitzes (125) aufweist, um ein Befestigungselement (122) aufzunehmen, das sich von einem Haltering (112), der unterhalb des Ringkörpers angeordnet ist, erstreckt, wobei das Befestigungselement sich in Richtung des Ringkörpers erstreckt, um den Ringkörper an dem Haltering zu befestigen;
eine Stufe, die an der Innenseite des Ringkörpers angeordnet ist, wobei die Stufe eine untere Fläche (1608) aufweist, die durch eine abgewinkelte Fläche (1606) von der Oberseite getrennt ist; und
eine oder mehrere gekrümmte Kanten.

2. Kartenring nach Anspruch 1, wobei der Kantenring verbrauchbar und austauschbar ist.

3. Kantenring nach Anspruch 1, wobei die eine oder mehreren gekrümmten Kanten eine gekrümmte Kante (1616) aufweisen, die zwischen der Oberseite und der Außenseite ausgebildet ist,
wobei die Innenseite die abgewinkelte Fläche (1606), eine horizontal ausgerichtete Fläche (1608) angrenzend an die abgewinkelte Fläche und die vertikal ausgerichtete Fläche (1610) angrenzend an die horizontal ausgerichtete Fläche der Innenseite aufweist,
wobei die Bodenseite horizontal ausgerichtet und angrenzend an die Außenseite und die vertikal ausgerichtete Innenfläche ist,
wobei die Außenseite eine vertikal ausgerichtete Außenfläche ist,
wobei die gekrümmte Kante benachbart zu der Oberseite und zu der Außenseite ist.

4. Kantenring nach Anspruch 1, wobei die Vielzahl von Gewindelöchern an der Bodenseite in gleichen Abständen beabstandet sind.

5. Kantenring nach Anspruch 1, wobei ein Spalt (Spalt 1) zwischen der oberen Fläche des Schlitzes und einem der Befestigungselemente, wenn es in dem Schlitz aufgenommen ist, kleiner als 1 mm ist, um die Wahrscheinlichkeit einer Bogenbildung in dem Spalt zu verringern.

6. Kantenring nach Anspruch 1, wobei der Ringkörper einen Außendurchmesser aufweist, der von etwa einschließlich 34,5 cm (13,6 Zoll) bis etwa einschließlich 38 cm (15 Zoll) reicht, wobei der Außendurchmesser durch die Außenseite begrenzt ist.

7. Kantenring nach Anspruch 1, wobei die eine oder mehreren gekrümmten Kanten eine gekrümmte Kante (1616) aufweisen, die zwischen der Oberseite und der Außenseite ausgebildet ist, wobei die gekrümmte Kante dazu ausgelegt ist, die Wahrscheinlichkeit einer Bogenbildung von der gekrümmten Kante bis zu einem Abdeckungsring (118) zu verringern, wenn sie benachbart zu der Außenseite angeordnet ist; oder
wobei die Oberseite einen Außendurchmesser von größer als 34,5 cm (13,6 Zoll) und höchstens 38 cm (15 Zoll) aufweist, um die Wahrscheinlichkeit einer Bogenbildung von der Oberseite bis zu einem Abdeckungsring (118) zu verringern, wenn sie benachbart zu der Außenseite angeordnet ist; oder
wobei alle Kanten des Kantenrings gebogen sind.

8. System zum sicheren Befestigen eines Kantenrings (108, 1650) einer Plasmakammer, das Folgendes umfasst:
den Kantenring;
einen Isolierring (106);
einen Haltering (112), der unterhalb des Kantenrings und oberhalb des Isolierrings angeordnet ist;
eine Gelschicht (110A, 110B), die zwischen einer Bodenfläche (1612) des Kantenrings und einer oberen Fläche des Halterings angeordnet ist;
eine Vielzahl von Schrauben (122), die dazu ausgelegt sind, den Kantenring sicher an dem Haltering zu befestigen, wobei jede aus der Vielzahl von Schrauben an einem entsprechenden aus einer Vielzahl von Schraubenlöchern (124A, 124B, 124C) befestigt ist, die in der Bodenfläche des Kantenrings angeordnet ist und durch den Haltering hindurch verläuft;
eine Vielzahl von Zugstangen (302A, 302B), die eine Vielzahl von Gewindegängen zum Ineingriffbringen mit einer Vielzahl von Gewindegängen aufweisen, die innerhalb einer Bodenfläche des Halterings ausgebildet sind; und
eine Vielzahl von pneumatischen Kolben (922), wobei jeder aus der Vielzahl von pneumatischen Kolben mit einer entsprechenden aus der Vielzahl von Zugstangen gekoppelt ist, wobei die Vielzahl von pneumatischen Kolben dazu ausgelegt ist, eine Zugkraft auf die Vielzahl von Zugstangen zu beaufschlagen, um gleichzeitig den Kantenring und den Haltering sicher an dem Isolierring zu befestigen, wobei der Kantenring und der Haltering gleichzeitig sicher mit dem Isolierring befestigt werden, um ein Substrat innerhalb der Plasmakammer zu bearbeiten.

9. System nach Anspruch 8, wobei die Vielzahl von pneumatischen Kolben dazu ausgelegt sind, die Vielzahl von Zugstangen nach oben zu drücken, um den Kantenring und den Haltering zur Wartung von der Plasmakammer zu lösen.

10. System nach Anspruch 9, wobei das System ferner Folgendes umfasst:
eine Vielzahl von Verschlussmechanismen (920A, 920B, 920C), die dazu ausgelegt sind, die Vielzahl von Zugstangen aufzuweisen, wobei jede aus der Vielzahl von Zugstangen einen Abschnitt, die sich innerhalb des Halterings erstreckt, und einen Abschnitt, der sich innerhalb des Isolierrings erstreckt, umfasst, wobei jeder aus der Vielzahl von Verschlussmechanismen dazu ausgelegt ist, eine entsprechende aus der Vielzahl von Zugstangen nach unten zu ziehen, um den Haltering und den Kantenring während eines Beabeitungsvorgangs in der Plasmakammer mit dem Isolierring in Eingriff zu bringen, und um den Haltering und den Kantenring in Bezug auf den Isolierring nach oben zu drücken, um den Haltering und den Kantenring freizugeben.

11. System nach Anspruch 10, wobei jeder aus der Vielzahl von Verschlussmechanismen Folgendes umfasst:
einen Luftzylinder (912);
einen Kolbenkörper (906) innerhalb des Luftzylinders;
eine Kolbenstange (916), die an dem Kolbenkörper befestigt ist; und
eine Halterung (604A), die dazu ausgelegt ist, eine entsprechende aus der Vielzahl von Zugstangen in Bezug auf den Luftzylinder zu montieren,
eine Luftführung (1102A), die dazu ausgelegt ist, komprimierte Luft zu oberen Abschnitten der Luftzylinder zuzuführen, um die Vielzahl von Zugstangen nach unten zu ziehen; und
eine Luftführung (1102B), die dazu ausgelegt ist, komprimierte Luft zu Bodenabschnitten der Luftzylinder zuzuführen, um die Vielzahl von Zugstangen nach oben zu drücken.

12. System nach Anspruch 8, wobei ein erster aus der Vielzahl von pneumatischen Kolben ein Teil eines ersten Verschlussmechanismus (920A) ist, wobei ein zweiter aus der Vielzahl von pneumatischen Kolben ein Teil eines zweiten Verschlussmechanismus (920B) ist, wobei ein dritter aus der Vielzahl von pneumatischen Kolben ein Teil eines dritten Verschlussmechanismus (920C) ist, wobei das System ferner Folgendes umfasst:
den zweiten Verschlussmechanismus, der dazu ausgelegt ist, den Haltering und den Kantenring sicher an dem Isolierring befestigen, und zwar an einer anderen Stelle verglichen mit der Stelle, an der der erste Verschlussmechanismus den Haltering und den Kantenring sicher an dem Isolierring befestigt;
den dritten Verschlussmechanismus, der dazu ausgelegt ist, den Haltering und den Kantenring sicher an dem Isolierring zu befestigen, und zwar an einer anderen Stelle verglichen mit der Stelle, an der der zweite Verschlussmechanismus den Haltering und den Kantenring sicher an dem Isolierring befestigt, und der Stelle, an der der erste Verschlussmechanismus den Haltering und den Kantenring sicher an dem Isolierring befestigt.

## Revendications

1. Anneau de bord destiné à être utilisé dans une chambre de traitement au plasma, l'anneau de bord (108, 1650) ayant un corps annulaire qui est configuré pour entourer un support de substrat (104) de la chambre de traitement au plasma, comprenant :
le corps annulaire ayant un côté inférieur (1612), un côté supérieur (1604), un côté interne (1620) et un côté externe (1614), dans lequel le corps annulaire est réalisé avec un matériau conducteur ;
une pluralité de trous filetés (124A, 124B, 124C) formés dans le corps annulaire le long du côté inférieur, dans lequel chacun de la pluralité de trous filetés s'étend à partir d'une surface orientée horizontalement du côté inférieur vers le côté supérieur, dans lequel chacun de la pluralité de trous filetés est partiellement enfermé par une surface supérieure (TS) d'une fente (125) formée à l'intérieur du côté inférieur de l'anneau de bord et une surface latérale (SS) de la fente (125), dans lequel la surface latérale est sensiblement perpendiculaire par rapport à la surface supérieure, dans lequel la surface orientée horizontalement s'étend de manière contiguë à partir d'une surface interne orientée verticalement (1610) du côté interne vers la pluralité de trous filetés, dans lequel chacun de la pluralité de trous filetés a une surface interne filetée (1652) sur la surface latérale de la fente (125) pour recevoir une fixation (122) qui s'étend à partir d'un anneau de support (112) positionné sous le corps annulaire, dans lequel la fixation s'étend vers le corps annulaire pour fixer le corps annulaire à l'anneau de support ;
un gradin disposé au niveau du côté interne du corps annulaire, le gradin ayant une surface inférieure (1608) séparée du côté supérieur par une surface coudée (1606) ; et
un ou plusieurs bords courbés.

2. Anneau de bord selon la revendication 1, dans lequel l'anneau de bord est consommable et remplaçable.

3. Anneau de bord selon la revendication 1, dans lequel les un ou plusieurs bords courbés comprennent un bord courbé (1616) formé entre le côté supérieur et le côté externe,
dans lequel le côté interne a la surface coudée (1606), une surface orientée horizontalement (1608) contiguë avec la surface coudée, et la surface interne orientée verticalement (1610) contiguë avec la surface orientée horizontalement du côté interne,
dans lequel le côté inférieur est orienté horizontalement et contigu avec le côté externe et la surface interne orientée verticalement,
dans lequel le côté externe est une surface externe orientée verticalement,
dans lequel le bord courbé est adjacent au côté supérieur et au côté externe.

4. Anneau de bord selon la revendication 1, dans lequel la pluralité de trous filetés sont espacés à égales distances sur le côté inférieur.

5. Anneau de bord selon la revendication 1, dans lequel un interstice (Interstice 1) entre la surface supérieure de la fente et l'une des fixations, lors de la réception dans la fente, est inférieur à un millimètre pour réduire les chances de formation d'arc dans l'interstice.

6. Anneau de bord selon la revendication 1, dans lequel le corps annulaire a un diamètre externe allant de et comprenant environ 34,5 cm (13,6 pouces) à environ 38 cm (15 pouces), dans lequel le diamètre externe est limité par le côté externe.

7. Anneau de bord selon la revendication 1, dans lequel les un ou plusieurs bords courbés comprennent un bord courbé (1616) formé entre le côté supérieur et le côté externe, dans lequel le bord courbé est configuré pour réduire les chances de formation d'arc du bord courbé à un anneau de couvercle (118) lorsqu'il est placé de manière adjacente au côté externe ; ou bien
dans lequel le côté supérieur a un diamètre externe supérieur à 34,5 cm (13,6 pouces) et au maximum 38 cm (15 pouces) pour réduire les chances de formation d'arc du côté supérieur à un anneau de couvercle (118), lorsqu'il est placé de manière adjacente au côté externe ; ou bien
dans lequel tous les bords de l'anneau de bord sont arqués.

8. Système pour fixer un anneau de bord (108, 1650) d'une chambre à plasma, comprenant :
l'anneau de bord ;
un anneau isolant (106) ;
un anneau de support (112) positionné sous l'anneau de bord et sur l'anneau isolant ;
une couche de gel (110A, 110B) disposée entre une surface inférieure (1612) de l'anneau de bord et une surface supérieure de l'anneau de support ;
une pluralité de vis (122) configurée pour fixer l'anneau de bord sur l'anneau de support, chacune de la pluralité de vis étant fixée sur un trou respectif d'une pluralité de trous de vis (124A, 124B, 124C) disposés dans la surface inférieure de l'anneau de bord et passant par l'anneau de support ;
une pluralité de tiges de retenue (302A, 302B) ayant une pluralité de filetages pour se mettre en prise avec une pluralité de filetages formés dans une surface inférieure de l'anneau de support ; et
une pluralité de pistons pneumatiques (922), dans lequel chacun de la pluralité de pistons pneumatiques est couplé à une tige respective de la pluralité de tiges de retenue, dans lequel la pluralité de pistons pneumatiques sont configurés pour appliquer une force de traction descendante sur la pluralité de tiges de retenue pour fixer simultanément l'anneau de bord et l'anneau de support sur l'anneau isolant, dans lequel l'anneau de bord et l'anneau de support sont simultanément fixés sur l'anneau isolant pour traiter un substrat dans la chambre à plasma.

9. Système selon la revendication 8, dans lequel la pluralité de pistons pneumatiques sont configurés pour pousser vers le haut la pluralité de tiges de retenue afin de retirer l'anneau de bord et l'anneau de support de la chambre à plasma pour entretien.

10. Système selon la revendication 8, le système comprenant en outre :
une pluralité de mécanismes de fermeture (920A, 920B, 920C) configurés pour avoir la pluralité de tiges de retenue, dans lequel chacune de la pluralité de tiges de retenue a une partie qui s'étend dans l'anneau de support et une partie qui s'étend à l'intérieur de l'anneau isolant, dans lequel chacun de la pluralité de mécanismes de fermeture est configuré pour pousser vers le bas une tige respective de la pluralité de tiges de retenue pour mettre en prise l'anneau de support et l'anneau de bord avec l'anneau isolant pendant une opération de traitement dans la chambre à plasma et pour pousser vers le haut l'anneau de support et l'anneau de bord par rapport à l'anneau isolant pour libérer l'anneau de support et l'anneau de bord.

11. Système selon la revendication 10, dans lequel chacun de la pluralité de mécanismes de fermeture comprend :
un cylindre pneumatique (912) ;
un corps de piston (906) à l'intérieur du cylindre pneumatique ;
une tige de piston (916) fixée au corps de piston ; et
un support (604A) configuré pour monter une tige respective de la pluralité de tiges de retenue par rapport au cylindre pneumatique,
un acheminement d'air (1102A) configuré pour alimenter l'air comprimé aux parties supérieures des cylindres pneumatiques pour tirer vers le bas la pluralité de tiges de retenue ; et
un acheminement d'air (1102B) configuré pour fournir l'air comprimé aux parties inférieures des cylindres pneumatiques pour pousser la pluralité de tiges de retenue vers le haut.

12. Système selon la revendication 8, dans lequel un premier de la pluralité de pistons pneumatiques fait partie d'un premier mécanisme de fermeture (920A), dans lequel un deuxième de la pluralité de pistons pneumatiques fait partie d'un deuxième mécanisme de fermeture (920B), dans lequel un troisième de la pluralité de pistons pneumatiques fait partie d'un troisième mécanisme de fermeture (920C), le système comprenant en outre :
le deuxième mécanisme de fermeture configuré pour fixer l'anneau de support et l'anneau de bord à l'anneau isolant à un emplacement différent par rapport à un emplacement auquel le premier mécanisme de fermeture fixe l'anneau de support et l'anneau de bord sur l'anneau isolant ;
le troisième mécanisme de fermeture configuré pour fixer l'anneau de support et l'anneau de bord sur l'anneau isolant à un emplacement différent par rapport à l'emplacement auquel le deuxième mécanisme de fermeture fixe l'anneau de support et l'anneau de bord à l'anneau isolant et l'emplacement auquel le premier mécanisme de fermeture fixe l'anneau de support et l'anneau de bord à l'anneau isolant.
